# EUROPEAN PATENT SPECIFICATION

(11) **EP 4 582 914 B1**
(45) Date of publication and mention of the grant of the patent: **09.09.2026**
(21) Application number: 24223754.3
(22) Date of filing: 30.12.2024
(51) Int. Cl.: G06F 3/041, G06F 3/044, H10K 59/124, H10K 59/131, H10K 59/40, H10K 59/80

(54) **INPUT SENSING PART AND DISPLAY DEVICE INCLUDING THE SAME**
EINGABEERFASSUNGSTEIL UND ANZEIGEVORRICHTUNG DAMIT
PARTIE DE DÉTECTION D'ENTRÉE ET DISPOSITIF D'AFFICHAGE LA COMPRENANT

(30) Priority: 02.01.2024 KR 20240000320
(43) Date of publication of application: 09.07.2025
(73) Proprietor: Samsung Display Co., Ltd., Yongin-si, Gyeonggi-do 17113 (KR)
(72) Inventor: KANG, BONGIL, 17113 Yongin-si (KR)
(74) Representative: Walaski, Jan Filip

(56) References cited:
- US-A1- 2021 333 942
- US-A1- 2022 035 486
- US-A1- 2023 176 699

## Description

### CROSS-REFERENCE TO RELATED APPLICATIONS

The present application claims priority to Korean Patent Application No. 10-2024-0000320, filed on 2 January 2024, in the Korean Intellectual Property Office.

### BACKGROUND

### 1. Field

The present disclosure relates to an input sensing part, and a display device including the input sensing part.

### 2. Description of the Related Art

In general, electronic devices, such as smart phones, digital cameras, notebook computers, car navigation units, smart televisions, and the like, that provide an image to a user include a display device for displaying the image. The display device generates an image, and provides the generated image to the user through a display screen.

The display device includes a display panel that generates an image, and an input sensing part that is disposed on the display panel and that senses an external input. The input sensing part is disposed on the display panel, and senses a touch of the user as an external input.

The above information disclosed in this Background section is for enhancement of understanding of the background of the present disclosure, and therefore, it may contain information that does not constitute prior art. US 2023/176699 A1, US 2022/035486 A1 and US 2021/333942 A1 disclose capacitive touch screens.

### SUMMARY

An input sensing part includes a plurality of sensing electrodes for sensing an external input, and a plurality of sensing lines connected to the sensing electrodes. The sensing electrodes are disposed in an active area, and the sensing lines may be disposed in an inactive area around the active area. It may be desirable to secure an area for an arrangement of the sensing lines, and therefore, the inactive area may be expanded. Accordingly, reducing the inactive area may be desired.

The invention is set out in the appended set of claims.

### BRIEF DESCRIPTION OF THE DRAWINGS

The above and other aspects and features of the present disclosure will be more clearly understood from the following detailed description of the illustrative, non-limiting embodiments with reference to the accompanying drawings.
FIG. 1 is a perspective view of a display device.
FIG. 2 is a sectional view of the display device illustrated in FIG. 1.
FIG. 3 is a sectional view of a display panel illustrated in FIG. 2.
FIG. 4 is a plan view of the display panel illustrated in FIG. 2.
FIG. 5 is a view illustrating sections of the display panel, an input sensing part, and an anti-reflective layer corresponding to one pixel illustrated in FIG. 4
FIG. 6 is a plan view of the input sensing part illustrated in FIG. 2.
FIG. 7 is a view illustrating components formed by a first conductive pattern in the input sensing part illustrated in FIG. 6.
FIG. 8 is a view illustrating components formed by a second conductive pattern in the input sensing part illustrated in FIG. 6.
FIG. 9 is an enlarged view of two first sensing parts and two second sensing parts that are adjacent to each other, an extending pattern, a connecting pattern, an extending line, and a second sensing line adjacent to the first and second sensing parts in FIG. 6.
FIG. 10 is a view separately illustrating the second sensing line, the connecting pattern, and the extending line illustrated in FIG. 9.
FIG. 11 is a view separately illustrating the first and second sensing parts and the extending pattern illustrated in FIG. 9.
FIG. 12 is a sectional view taken along the line I-I' illustrated in FIG. 9.
FIG. 13 is a sectional view taken along line the II-II' illustrated in FIG. 9.
FIG. 14 is a view illustrating a configuration of an input sensing part.
FIG. 15 is an enlarged view of two first sensing parts and two second sensing parts that are adjacent to each other, an extending pattern, a connecting pattern, an extending line, and a second sensing line adjacent to the first and second sensing parts in FIG. 14.
FIG. 16 is a view separately illustrating the second sensing line, the connecting pattern, and first, second, and third sub-extending lines illustrated in FIG. 15.
FIG. 17 is a view separately illustrating the first and second sensing parts, the extending pattern, and bridge portions illustrated in FIG. 15.
FIG. 18 is a sectional view taken along the line III-III' illustrated in FIG. 15.
FIGS. 19-23 are views illustrating configurations of extending lines.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

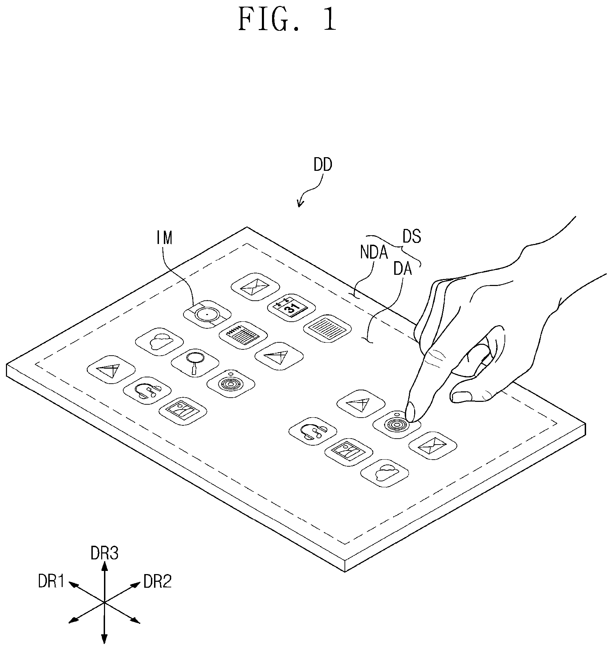

FIG. 1 is a perspective view of a display device.

Referring to FIG. 1, the display device DD may have a rectangular shape with long sides extending in a first direction DR1 and short sides extending in a second direction DR2 crossing the first direction DR1. However, it is not limited thereto, and the display device DD may have various suitable shapes, such as a circular shape, a polygonal shape, and the like. The first direction DR1 and the second direction DR2 may cross perpendicularly or substantially perpendicularly to each other when viewed on a plane (e.g., in a plan view).

Hereinafter, a direction that is perpendicular to or substantially perpendicular to a plane defined by the first direction DR1 and the second direction DR2 is defined as a third direction DR3. As used herein, the expressions "when viewed on the plane" and "in a plan view" may mean that an object portion is viewed in the third direction DR3. In addition, each of the first direction DR1, the second direction DR2, and the third direction DR3 may be defined in both (e.g., opposite) directions.

The upper surface of the display device DD may be defined as a display surface DS, and may have a plane defined by the first direction DR1 and the second direction DR2. Images IM generated by the display device DD may be provided to a user through the display surface DS.

The display surface DS may include a display area DA, and a non-display area NDA around the display area DA. The display area DA may display an image, and the non-display area NDA may not display an image. The non-display area NDA may surround (e.g., around a periphery of) the display area DA, and may define the border of the display device DD that is printed in a desired color (e.g., a certain or predetermined color).

The display device DD may be used in large electronic devices, such as a television, a monitor, or a billboard. In addition, the display device DD may be used in small and medium-sized electronic devices, such as a personal computer, a notebook computer, a personal digital terminal, a car navigation unit (e.g., a car navigation device), a game machine, a smart phone, a tablet computer, and a camera. However, it is not limited thereto, and the display device DD may be used in other suitable electronic devices without departing from the scope of the present disclosure.

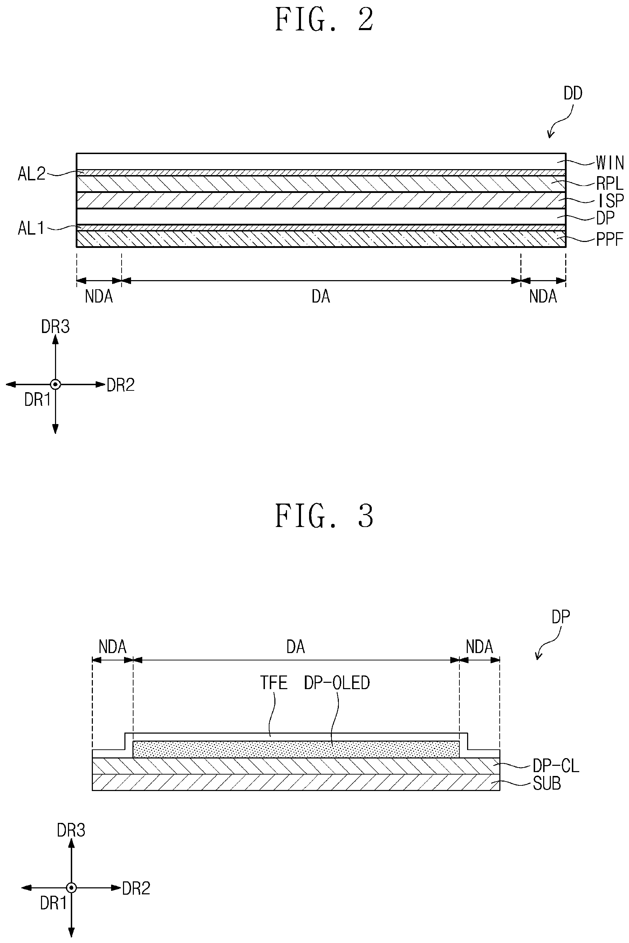

FIG. 2 is a sectional view of the display device illustrated in FIG. 1.

In FIG. 2, a section of the display device DD viewed in the first direction DR1 is illustrated.

Referring to FIG. 2, the display device DD may include a display panel DP, an input sensing part ISP, an anti-reflective layer RPL, a window WIN, a panel protection film PPF, and first and second adhesive layers AL1 and AL2.

The display panel DP may be a flexible display panel. The display panel DP may be an emissive display panel. For example, the display panel DP may be an organic light emitting display panel or an inorganic light emitting display panel. An emissive layer of the organic light emitting display panel may include an organic luminescent material. An emissive layer of the inorganic light emitting display panel may include quantum dots, quantum rods, and/or the like. Hereinafter, for convenience of illustration, the display panel DP may be described in more detail in the context of an organic light emitting display panel.

The input sensing part ISP may be disposed on the display panel DP. The input sensing part ISP may include a plurality of sensing parts for sensing an external input in a capacitive type. The input sensing part ISP may be directly manufactured on the display panel DP when the display device DD is manufactured. However, it is not limited thereto, and the input sensing part ISP may be manufactured as a panel separate from the display panel DP and may be attached to the display panel DP by an adhesive layer.

The anti-reflective layer RPL may be disposed on the input sensing part ISP. The anti-reflective layer RPL may be directly manufactured on the input sensing part ISP when the display device DD is manufactured. However, it is not limited thereto, and the anti-reflective layer RPL may be manufactured as a separate panel and may be attached to the input sensing part ISP by an adhesive layer.

The anti-reflective layer RPL may be defined as a film for preventing or substantially preventing a reflection of external light. The anti-reflective layer RPL may decrease the reflectance of external light incident toward the display panel DP from above the display device DD. Due to the anti-reflective layer RPL, the external light may not be visible to the user.

When external light travelling toward the display panel DP is reflected from the display panel DP and provided back to the user, the user may visually recognize the external light like in a mirror. To prevent or substantially prevent such a phenomenon, the anti-reflective layer RPL may include a plurality of color filters that display the same colors as those of the pixels of the display panel DP.

The color filters may filter the external light into the same colors as those of the pixels. In this case, the external light may not be visible to the user. However, the anti-reflective layer RPL may include a phase retarder and/or a polarizer to decrease the reflectance of the external light.

The window WIN may be disposed on the anti-reflective layer RPL. The window WIN may protect the display panel DP, the input sensing part ISP, and the anti-reflective layer RPL from external scratches and impacts.

The panel protection film PPF may be disposed under the display panel DP. The panel protection film PPF may protect a lower portion of the display panel DP. The panel protection film PPF may include a flexible plastic material such as polyethylene terephthalate (PET).

The first adhesive layer AL1 may be disposed between the display panel DP and the panel protection film PPF, and the display panel DP and the panel protection film PPF may be bonded to each other by the first adhesive layer AL1. The second adhesive layer AL2 may be disposed between the window WIN and the anti-reflective layer RPL, and the window WIN and the anti-reflective layer RPL may be bonded to each other by the second adhesive layer AL2.

FIG. 3 is a sectional view of the display panel illustrated in FIG. 2.

In FIG. 3, a section of the display panel DP viewed in the first direction DR1 is illustrated.

Referring to FIG. 3, the display panel DP may include a substrate SUB, a circuit element layer DP-CL disposed on the substrate SUB, a display element layer DP-OLED disposed on the circuit element layer DP-CL, and a thin film encapsulation layer TFE disposed on the display element layer DP-OLED.

The substrate SUB may include a display area DA, and a non-display area NDA around the display area DA. The substrate SUB may include a flexible plastic material such as glass or polyimide (PI). The display element layer DP-OLED may be disposed on the display area DA.

A plurality of pixels may be disposed in the circuit element layer DP-CL and the display element layer DP-OLED. Each of the pixels may include transistors disposed in the circuit element layer DP-CL, and a light emitting element disposed in the display element layer DP-OLED and connected to the transistors.

The thin film encapsulation layer TFE may be disposed on the circuit element layer DP-CL to cover the display element layer DP-OLED. The thin film encapsulation layer TFE may protect the pixels from moisture, oxygen, and external foreign matter.

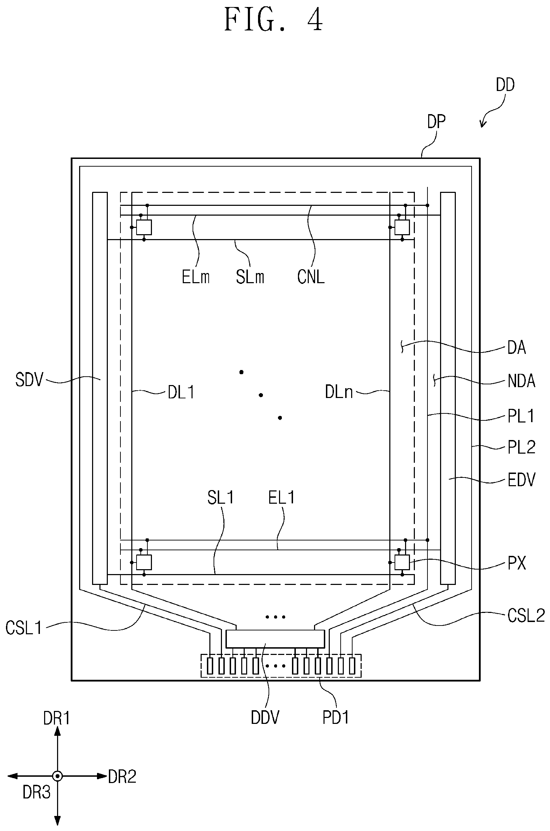

FIG. 4 is a plan view of the display panel illustrated in FIG. 2.

Referring to FIG. 4, the display device DD may include the display panel DP, a scan driver SDV, a data driver DDV, a light emission driver EDV, and a plurality of first pads PD1.

The display panel DP may have a rectangular shape with long sides extending in the first direction DR1 and short sides extending in the second direction DR2. However, the shape of the display panel DP is not limited thereto. The display panel DP may include a display area DA, and a non-display area NDA surrounding (e.g., around a periphery of) the display area DA.

The display panel DP may include a plurality of pixels PX, a plurality of scan lines SL1 to SLm, a plurality of data lines DL1 to DLn, a plurality of light emission lines EL1 to ELm, first and second control lines CSL1 and CSL2, first and second power lines PL1 and PL2, and a plurality of connecting lines CNL, where "m" and "n" are natural numbers.

The pixels PX may be disposed in the display area DA. The scan driver SDV and the light emission driver EDV may be disposed in the non-display areas NDA adjacent to the long sides of the display panel DP, respectively. The data driver DDV may be disposed in the non-display area NDA adjacent to one of the short sides of the display panel DP. The data driver DDV may be adjacent to the lower end of the display panel DP when viewed on the plane (e.g., in a plan view).

The scan lines SL1 to SLm may extend in the second direction DR2, and may be connected to the pixels PX and the scan driver SDV. The data lines DL1 to DLn may extend in the first direction DR1, and may be connected to the pixels PX and the data driver DDV. The light emission lines EL1 to ELm may extend in the second direction DR2, and may be connected to the pixels PX and the light emission driver EDV.

The first power line PL1 may extend in the first direction DR1, and may be disposed in the non-display area NDA. The first power line PL1 may be disposed between the display area DA and the light emission driver EDV.

The connecting lines CNL may extend in the second direction DR2, and may be arranged along the first direction DR1 and connected to the first power line PL1 and the pixels PX. A first voltage may be applied to the pixels PX through the first power line PL1 and the connecting lines CNL connected with each other.

The second power line PL2 may be disposed in the non-display area NDA, and may extend along the long sides of the display panel DP and the other short side of the display panel DP where the data driver DDV is not disposed. The second power line PL2 may be disposed outward of the scan driver SDV and the light emission driver EDV.

The second power line PL2 may extend toward the display area DA, and may be connected to the pixels PX. A second voltage having a lower level than that of the first voltage may be applied to the pixels PX through the second power line PL2.

The first control line CSL1 may be connected to the scan driver SDV, and may extend toward the lower end of the display panel DP. The second control line CSL2 may be connected to the light emission driver EDV, and may extend toward the lower end of the display panel DP. The data driver DDV may be disposed between the first control line CSL1 and the second control line CSL2.

The first pads PD1 may be disposed in the non-display area NDA adjacent to the lower end of the display panel DP, and may be closer to the lower end of the display panel DP than the data driver DDV. The data driver DDV, the first and second power lines PL1 and PL2, and the first and second control lines CSL1 and CSL2 may be connected to the first pads PD1. The data lines DL1 to DLn may be connected to the data driver DDV, and the data driver DDV may be connected to the first pads PDs corresponding to the data lines DL1 to DLn.

The display device DD may further include a timing controller for controlling operations of the scan driver SDV, the data driver DDV, and the light emission driver EDV, and a voltage generator for generating the first and second voltages. The timing controller and the voltage generator may be mounted on a printed circuit board, and may be connected to the first pads PD1 through the printed circuit board.

The scan driver SDV may generate a plurality of scan signals, and the scan signals may be applied to the pixels PX through the scan lines SL1 to SLm. The data driver DDV may generate a plurality of data voltages, and the data voltages may be applied to the pixels PX through the data lines DL1 to DLn. The light emission driver EDV may generate a plurality of light emission signals, and the light emission signals may be applied to the pixels PX through the light emission lines EL1 to ELm.

The pixels PX may receive the data voltages in response to the scan signals. The pixels PX may display an image by emitting light having luminances corresponding to the data voltages in response to the light emission signals.

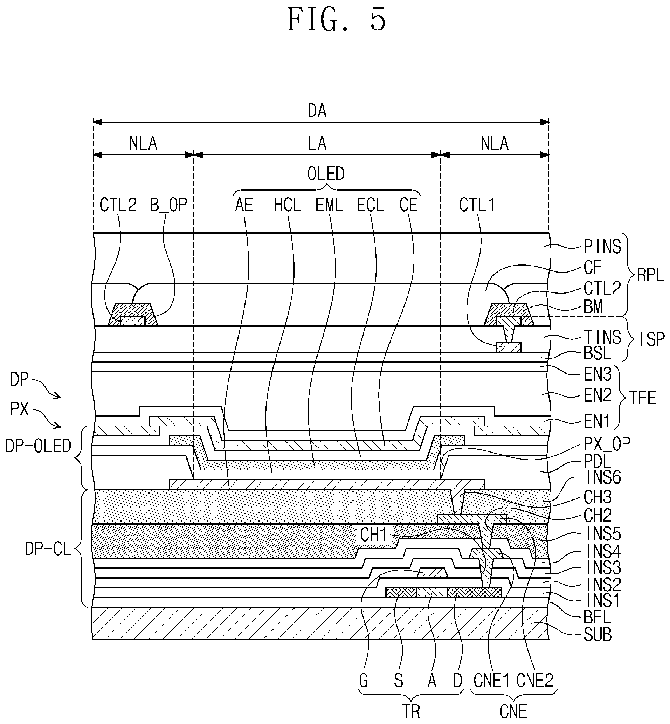

FIG. 5 is a view illustrating sections of the display panel, the input sensing part, and the anti-reflective layer corresponding to one pixel illustrated in FIG. 4.

Referring to FIG. 5, the pixel PX may include a transistor TR and a light emitting element OLED. The light emitting element OLED may include a first electrode AE (e.g., an anode), a second electrode CE (e.g., a cathode), a hole control layer HCL, an electron control layer ECL, and an emissive layer EML.

The transistor TR and the light emitting element OLED may be disposed on the substrate SUB. Although one transistor TR is illustrated as an example, the pixel PX may substantially include a plurality of transistors and at least one capacitor for driving the light emitting element OLED.

The display area DA may include an emissive area LA corresponding to each of the pixels PX, and a non-emissive area NLA around the emissive area LA. The light emitting element OLED may be disposed in the emissive area LA.

A buffer layer BFL may be disposed on the substrate SUB. The buffer layer BFL may be an inorganic layer. A semiconductor pattern may be disposed on the buffer layer BFL. The semiconductor pattern may include poly silicon, amorphous silicon, or a metal oxide.

The semiconductor pattern may be doped with an N-type dopant or a P-type dopant. The semiconductor pattern may include highly-doped areas and a lightly-doped area. The highly-doped areas may have a higher conductivity than that of the lightly-doped area, and may substantially serve as a source electrode and a drain electrode of the transistor TR. The lightly-doped area may substantially correspond to an active (e.g., a channel) area of the transistor TR.

The source S, the active area A, and the drain D of the transistor TR may be formed from the semiconductor pattern. A first insulating layer INS1 may be disposed on the semiconductor pattern. A gate G of the transistor TR may be disposed on the first insulating layer INS1. A second insulating layer INS2 may be disposed on the gate G. A third insulating layer INS3 may be disposed on the second insulating layer INS2.

To connect the transistor TR and the light emitting element OLED to each other, a connecting electrode CNE may include a first connecting electrode CNE1 and a second connecting electrode CNE2. The first connecting electrode CNE1 may be disposed on the third insulating layer INS3, and may be connected to the drain D through a first contact hole CH1 defined in the first to third insulating layers INS1 to INS3.

A fourth insulating layer INS4 may be disposed on the first connecting electrode CNE1. A fifth insulating layer INS5 may be disposed on the fourth insulating layer INS4. The second connecting electrode CNE2 may be disposed on the fifth insulating layer INS5. The second connecting electrode CNE2 may be connected to the first connecting electrode CNE1 through a second contact hole CH2 defined in the fourth and fifth insulating layers INS4 and INS5.

A sixth insulating layer INS6 may be disposed on the second connecting electrode CNE2. The layers from the buffer layer BFL to the sixth insulating layer INS6 may be defined as the circuit element layer DP-CL. The first to sixth insulating layers INS1 to INS6 may be inorganic layers or organic layers.

The first electrode AE may be disposed on the sixth insulating layer INS6. The first electrode AE may be connected to the second connecting electrode CNE2 through a third contact hole CH3 defined in the sixth insulating layer INS6. A pixel defining layer PDL having an opening PX_OP defined therein to expose a portion (e.g., a certain or predetermined portion) of the first electrode AE may be disposed on the first electrode AE and the sixth insulating layer INS6.

The hole control layer HCL may be disposed on the first electrode AE and the pixel defining layer PDL. The hole control layer HCL may include a hole transport layer and/or a hole injection layer.

The emissive layer EML may be disposed on the hole control layer HCL. The emissive layer EML may be disposed in an area corresponding to the opening PX_OP. The emissive layer EML may include an organic material and/or an inorganic material. The emissive layer EML may generate one of red light, green light, and/or blue light.

The electron control layer ECL may be disposed on the emissive layer EML and the hole control layer HCL. The electron control layer ECL may include an electron transport layer and/or an electron injection layer. The hole control layer HCL and the electron control layer ECL may be commonly disposed in the emissive area LA and the non-emissive area NLA.

The second electrode CE may be disposed on the electron control layer ECL. The second electrode CE may be commonly disposed for the pixels PX. The layer in which the light emitting element OLED is disposed may be defined as the display element layer DP-OLED.

The thin film encapsulation layer TFE may be disposed on the second electrode CE, and may cover the pixel PX. The thin film encapsulation layer TFE may include a first encapsulation layer EN1 disposed on the second electrode CE, a second encapsulation layer EN2 disposed on the first encapsulation layer EN1, and a third encapsulation layer EN3 disposed on the second encapsulation layer EN2.

The first and third encapsulation layers EN1 and EN3 may include an inorganic insulating layer, and may protect the pixel PX from moisture/oxygen. The second encapsulation layer EN2 may include an organic insulating layer, and may protect the pixel PX from foreign matter such as dust particles.

The first voltage may be applied to the first electrode AE through the transistor TR, and the second voltage having a lower level than that of the first voltage may be applied to the second electrode CE. Holes and electrons injected into the emissive layer EML may be combined together to form excitons, and as the excitons transition to a ground state, the light emitting element OLED may emit light.

The input sensing part ISP may be disposed on the thin film encapsulation layer TFE. The input sensing part ISP may be directly disposed on the upper surface of the thin film encapsulation layer TFE.

A base layer BSL may be disposed on the thin film encapsulation layer TFE. The base layer BSL may include an inorganic insulating layer. At least one inorganic insulating layer may be disposed on the thin film encapsulation layer TFE as the base layer BSL.

The input sensing part ISP may include a first conductive pattern CTL1, and a second conductive pattern CTL2 disposed on the first conductive pattern CTL1. The first conductive pattern CTL1 may be disposed on the base layer BSL. An insulating layer TINS may be disposed on the base layer BSL to cover the first conductive pattern CTL1. The insulating layer TINS may include an inorganic insulating layer or an organic insulating layer. The second conductive pattern CTL2 may be disposed on the insulating layer TINS.

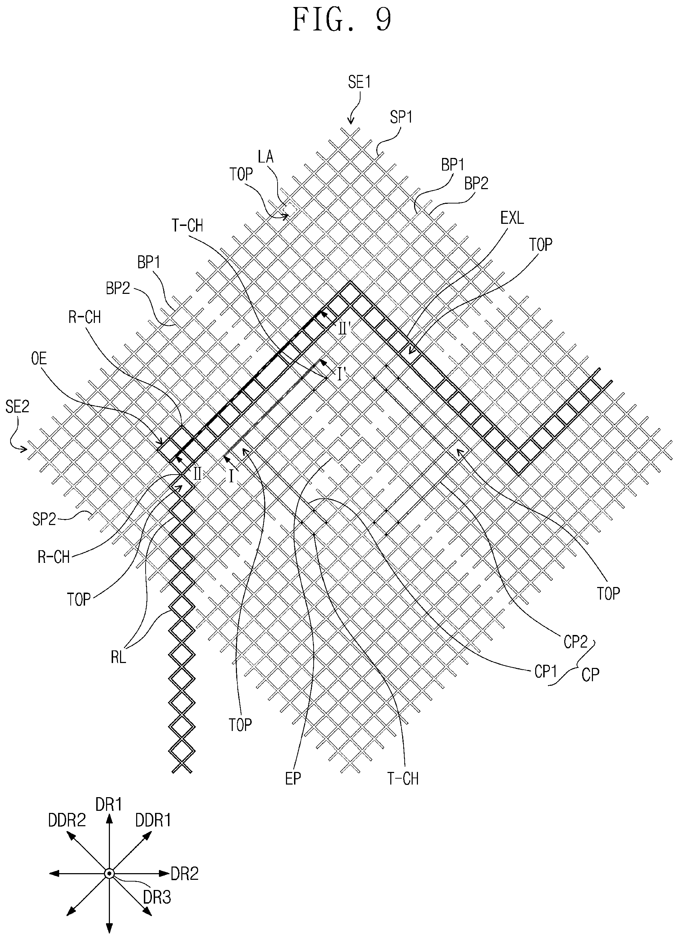

The first and second conductive patterns CTL1 and CTL2 may overlap with the non-emissive area NLA. The first and second conductive patterns CTL1 and CTL2 may be disposed on the non-emissive area NLA between the emissive areas LA, and may have a mesh shape. The mesh shape of the first and second conductive patterns CTL1 and CTL2 is illustrated in, for example, FIG. 9.

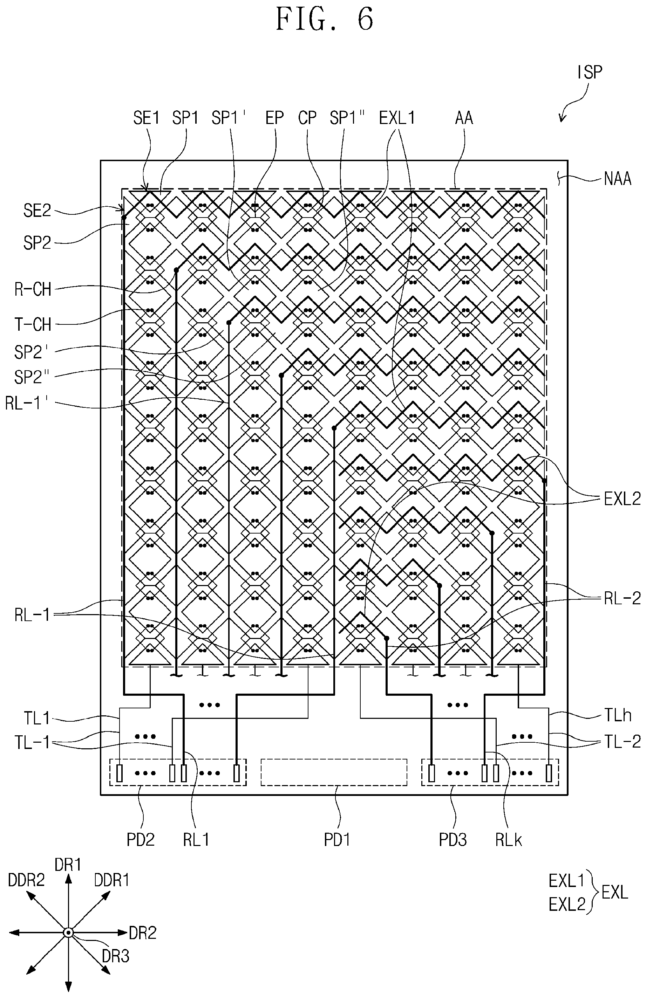

The first and second conductive patterns CTL1 and CTL2 may form the sensing parts of the input sensing part ISP described above. For example, the first and second conductive patterns CTL1 and CTL2 having the mesh shape may be spaced (e.g., separated) from each other in a certain area to form the sensing parts. A portion of the second conductive pattern CTL2 may be connected to the first conductive pattern CTL1. The configuration of the sensing parts formed by the first and second conductive patterns CTL1 and CTL2 will be described in more detail below with reference to FIGS. 6 to 9.

The anti-reflective layer RPL may be disposed on the second conductive pattern CTL2. The anti-reflective layer RPL may include a black matrix BM and a plurality of color filters CF. The black matrix BM may overlap with the non-emissive area NLA, and the color filters CF may overlap with the emissive areas LA, respectively.

The black matrix BM may be disposed on the insulating layer TINS to cover the second conductive pattern CTL2. An opening B_OP overlapping with the emissive area LA and the opening PX_OP may be defined in the black matrix BM. The black matrix BM may absorb and block light. The width of the opening B_OP may be greater than the width of the opening PX_OP.

The color filters CF may be disposed on the insulating layer TINS and the black matrix BM. The color filters CF may be disposed in the openings B_OP, respectively. A planarization insulating layer PINS may be disposed on the color filters CF. The planarization insulating layer PINS may provide a flat or substantially flat upper surface.

The color filters CF may have the same colors as those of the pixels PX. The color filters CF may filter external light into the same colors as those of the pixels PX. In this case, the external light may not be visible to the user.

FIG. 6 is a plan view of the input sensing part illustrated in FIG. 2.

Referring to FIG. 6, the input sensing part ISP may include a plurality of sensing electrodes SE1 and SE2, a plurality of sensing lines TL1 to TLh and RL1 to RLk, a plurality of second pads PD2, a plurality of third pads PD3, and a plurality of extending lines EXL, where "h" and "k" are natural numbers. The sensing electrodes SE1 and SE2, the first and second sensing lines TL1 to TLh and RL1 to RLk, the second and third pads PD2 and PD3, and the extending lines EXL may be disposed on the thin film encapsulation layer TFE.

A planar area of the input sensing part ISP may include an active area AA, and an inactive area NAA around the active area AA. The active area AA may overlap with the display area DA, and the inactive area NAA may overlap with the non-display area NDA. The inactive area NAA may surround (e.g., around a periphery of) the active area AA.

The sensing electrodes SE1 and SE2 may be disposed in the active area AA, and the second and third pads PD2 and PD3 may be disposed in the inactive area NAA. The second pads PD2 and the third pads PD3 may be adjacent to the lower end of the input sensing part ISP when viewed on the plane (e.g., in a plan view). For example, the second pads PD2 may be disposed on the left side, and the third pads PD3 may be disposed on the right side. The first pads PD1 may be disposed between the second pads PD2 and the third pads PD3 when viewed on the plane (e.g., in a plan view).

The sensing lines TL1 to TLh and RL1 to RLk may be connected to the sensing electrodes SE1 and SE2. The sensing lines TL1 to TLh and RL1 to RLk may be connected to the second and third pads PD2 and PD3 in the inactive area NAA. A sensing controller for controlling the input sensing part ISP may be connected to the second and third pads PD2 and PD3 through a printed circuit board.

The sensing electrodes SE1 and SE2 may include a plurality of first sensing electrodes SE1 that extend in the first direction DR1 and arranged along the second direction DR2, and a plurality of second sensing electrodes SE2 that extend in the second direction DR2 and arranged along the first direction DR1. The second sensing electrodes SE2 may extend to cross the first sensing electrodes SE1, while being insulated from the first sensing electrodes SE1.

The sensing lines TL1 to TLh and RL1 to RLk may include a plurality of first sensing lines TL1 to TLh connected to the first sensing electrodes SE1, and a plurality of second sensing lines RL1 to RLk connected to the second sensing electrodes SE2. Here, "h" and "k" are natural numbers.

The first sensing lines TL1 to TLh may be disposed in the inactive area NAA. The first sensing lines TL1 to TLh may be connected to first ends of the first sensing electrodes SE1, respectively, and may be connected to the second and third pads PD2 and PD3 in the inactive area NAA. When viewed on the plane, the first sensing lines TL1 to TLh may be disposed in the inactive area NAA adjacent to the lower side of the active area AA, and may be connected to the lower ends of the first sensing electrodes SE1, respectively.

Among the first sensing lines TL1 to TLh, first sensing lines TL-1 may be connected to corresponding second pads PD2, respectively, and first sensing lines TL-2 may be connected to corresponding third pads PD3, respectively.

For example, among the first sensing lines TL1 to TLh, the first sensing lines TL-1 disposed on the left side with respect to the center of the active area AA may be connected to the second pads PD2. In addition, among the first sensing lines TL1 to TLh, the first sensing lines TL-2 disposed on the right side with respect to the center of the active area AA may be connected to the third pads PD3.

The second sensing lines RL1 to RLk may be disposed in the AA, and may extend in the first direction DR1. For example, the second sensing lines RL1 to RLk are illustrated by thick lines. The second sensing lines RL1 to RLk may be connected to the second sensing electrodes SE2, respectively, in the active area AA. For example, first ends (e.g., upper ends) of the second sensing lines RL1 to RLk may be connected to the second sensing electrodes SE2, respectively.

When viewed on the plane, the second sensing lines RL1 to RLk may extend to the inactive area NAA adjacent to the lower side of the active area AA, and may be connected to the second and third pads PD2 and PD3. Among the second sensing lines RL1 to RLk, second sensing lines RL-1 may be connected to corresponding second pads PD2, respectively, and second sensing lines RL-2 may be connected to corresponding third pads PD3, respectively.

For example, the second sensing lines RL-1 may be defined as a number (e.g., a certain or predetermined number) of second sensing lines from the left side of the active area AA. The second sensing lines RL-2 may be defined as the remaining second sensing lines other than the second sensing lines RL-1.

Hereinafter, a direction crossing the first and second directions DR1 and DR2 on the plane defined by the first and second directions DR1 and DR2 may be defined as a first diagonal direction DDR1. A direction crossing the first diagonal direction DDR1 on the plane defined by the first and second directions DR1 and DR2 may be defined as a second diagonal direction DDR2. The first diagonal direction DDR1 and the second diagonal direction DDR2 may cross perpendicularly or substantially perpendicularly to each other.

The second sensing lines RL-1 may be sequentially disposed from the upper end of the active area AA toward the right side and the lower end, and may be connected to corresponding second sensing electrodes SE2, respectively. For example, in the active area AA, first ends of the second sensing lines RL-1 may be disposed along the second diagonal direction DDR2, and may be connected to the corresponding second sensing electrodes SE2, respectively. The second sensing electrodes SE2 corresponding to the second sensing lines RL-1 may be sequentially connected to the second sensing lines RL-1, respectively, from the upper end of the active area AA.

The second sensing lines RL-2 may be sequentially disposed from the lower end of the active area AA toward the right side and the upper end, and may be connected to corresponding second sensing electrodes SE2, respectively. For example, in the active area AA, first ends of the second sensing lines RL-2 may be disposed along the first diagonal direction DDR1, and may be connected to the corresponding second sensing electrodes SE2, respectively. The second sensing electrodes SE2 corresponding to the second sensing lines RL-2 may be sequentially connected to the second sensing lines RL-2, respectively, from the lower end of the active area AA.

The connection positions of the second sensing lines RL1 to RLk with respect to the second sensing electrodes SE2 described above are provided as an example illustrated in FIG. 6, and are not limited thereto. In other words, the second sensing lines RL1 to RLk may be connected to the second sensing electrodes SE2 at various suitable positions, respectively.

In the inactive area NAA, the first sensing lines TL-1 and the second sensing lines RL-1 connected to the second pads PD2 may extend to cross each other while being insulated from each other. In the inactive area NAA, the first sensing lines TL-2 and the second sensing lines RL-2 connected to the third pads PD3 may extend to cross each other while being insulated from each other.

Drive signals may be transmitted to the first sensing electrodes SE1 through the first sensing lines TL1 to TLh. Sensing signals may be output through the second sensing lines RL1 to RLk connected to the second sensing electrodes SE2.

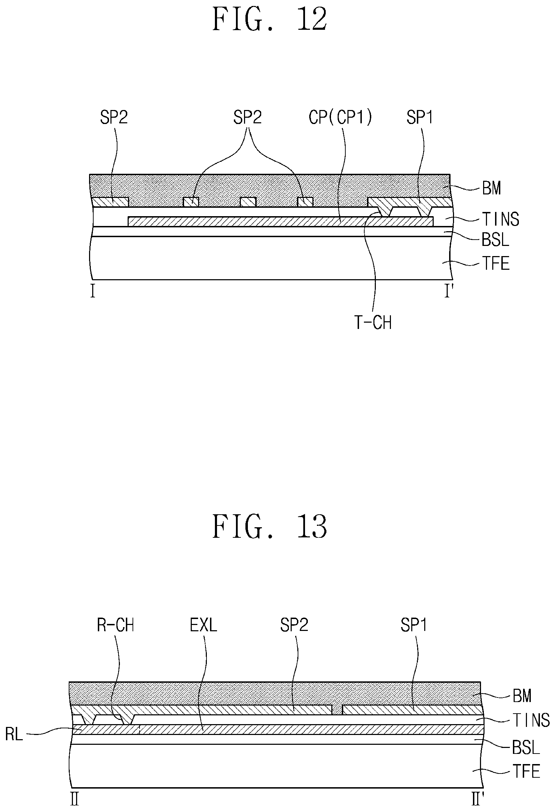

Each of the first sensing electrodes SE1 may include a plurality of first sensing parts SP1 arranged along the first direction DR1, and a plurality of connecting patterns CP connecting the first sensing parts SP1 to one another. Each of the connecting patterns CP may be disposed between two first sensing parts SP1 that are adjacent to each other in the first direction DR1, and may connect the two first sensing parts SP1 to each other. The connecting patterns CP may be connected to the first sensing parts SP1 through a plurality of contact holes T-CH. The contact holes T-CH are described in more detail below with reference to FIGS. 9 and 12.

Each of the second sensing electrodes SE2 may include a plurality of second sensing parts SP2 arranged along the second direction DR2, and a plurality of extending patterns EP extending from the second sensing parts SP2. Each of the extending patterns EP may be disposed between two second sensing parts SP2 that are adjacent to each other in the second direction DR2, and may extend from the two second sensing parts SP2.

The first sensing parts SP1 and the second sensing parts SP2 may be spaced apart from each other without overlapping with each other, and may be alternately disposed. The first sensing parts SP1 and the second sensing parts SP2 may be alternately disposed along the first diagonal direction DDR1, and may be alternately disposed along the second diagonal direction DDR2. A capacitance may be formed by the first sensing parts SP1 and the second sensing parts SP2. The extending patterns EP may not overlap with the connecting patterns CP when viewed on the plane (e.g., in a plan view).

Each of the second sensing lines RL1 to RLk may be connected to one second sensing part SP2 of a corresponding second sensing electrode SE2 among the second sensing electrodes SE2. For example, when viewed on the plane (e.g., in a plan view), a first end of each of the second sensing lines RL1 to RLk may overlap with the one second sensing part SP2 of the corresponding second sensing electrode SE2, and may be connected to the one second sensing part SP2 of the corresponding second sensing electrode SE2.

For example, the first end of each of the second sensing lines RL1 to RLk may overlap with the central portion of the one second sensing part SP2 of the corresponding second sensing electrode SE2. The first end of each of the second sensing lines RL1 to RLk may be connected to the one second sensing part SP2 of the corresponding second sensing electrode SE2 through a contact hole R-CH. A plurality of contact holes R-CH may be substantially provided for each of the second sensing lines RL1 to RLk, which will be described in more detail below with reference to FIGS. 9 and 13.

The second sensing parts SP2 connected to the second sensing lines RL-1 may be arranged along the second diagonal direction DDR2. The second sensing parts SP2 connected to the second sensing lines RL-2 may be arranged along the first diagonal direction DDR1.

The extending lines EXL may be disposed in the active area AA, and may be connected to the second sensing lines RL1 to RLk, respectively. Accordingly, the extending lines EXL may be connected to the second sensing electrodes SE2 through the second sensing lines RL1 to RLk, respectively. For example, the extending lines EXL are illustrated by thick lines in FIG. 6.

The extending lines EXL may extend from the second sensing lines RL1 to RLk in the second direction DR2. For example, the extending lines EXL may be connected to the first ends of the second sensing lines RL1 to RLk, respectively, and may extend from the first ends of the second sensing lines RL1 to RLk in the second direction DR2. The extending lines EXL may extend from the first ends of the second sensing lines RL1 to RLk in one direction (e.g., a direction parallel to or substantially parallel to the second direction DR2).

The extending lines EXL may include a plurality of first extending lines EXL1 connected to the second sensing lines RL-1, respectively, and a plurality of second extending lines EXL2 connected to the second sensing lines RL-2, respectively. The first extending lines EXL1 and the second extending lines EXL2 may extend in opposite directions from each other.

The first extending lines EXL1 may be connected to the first ends of the second sensing lines RL-1, respectively, and may extend from the first ends of the second sensing lines RL-1 in one direction parallel to or substantially parallel to the second direction DR2. The second extending lines EXL2 may be connected to the first ends of the second sensing lines RL-2, respectively, and may extend from the first ends of the second sensing lines RL-2 in another direction (e.g., an opposite direction) parallel to or substantially parallel to the second direction DR2.

The extending lines EXL may be bent at least once, and may extend in zigzags in the second direction DR2. When viewed on the plane, the extending lines EXL may extend to bypass the connecting patterns CP so as not to overlap with the connecting patterns CP.

The extending lines EXL may extend via the first sensing parts SP1 in the second direction DR2. For example, each of the extending lines EXL may extend via the first sensing parts SP1 disposed along the extension direction of the extending line EXL (e.g., along a direction parallel to or substantially parallel to the second direction DR2). In addition, the extending line EXL may extend via the second sensing parts SP2 disposed along the extension direction of the extending line EXL.

According to the above-described structure, the extending line EXL may overlap with portions of the first sensing parts SP1 and portions of the second sensing parts SP2 disposed along the extension direction of the extending line EXL.

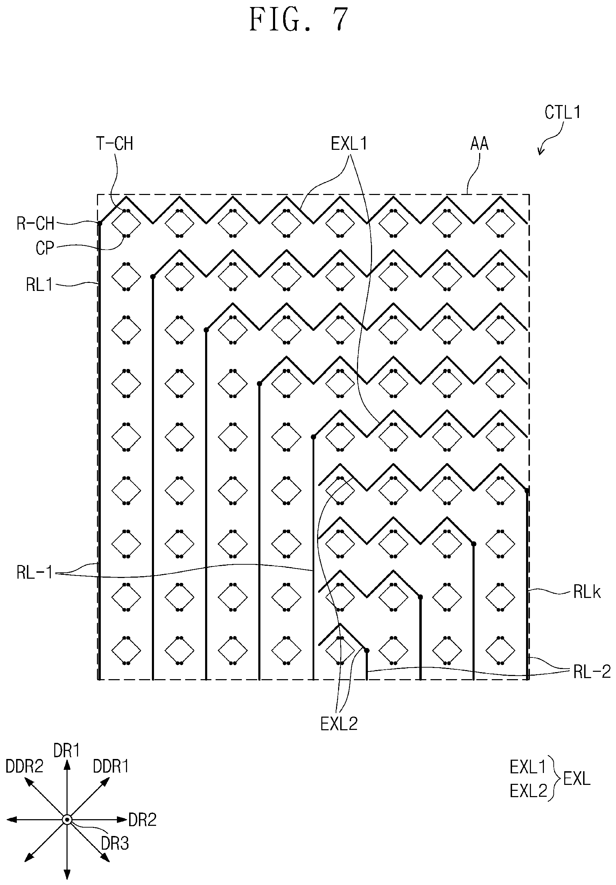

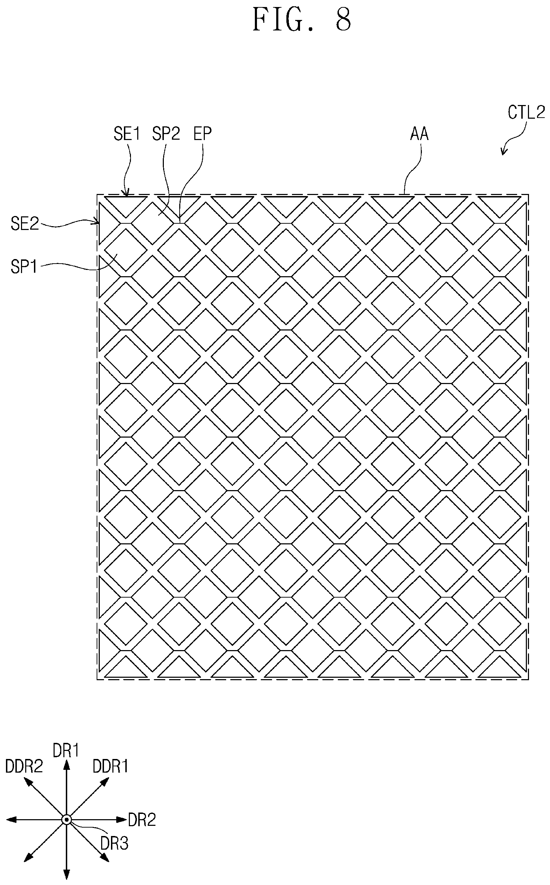

FIG. 7 is a view illustrating components formed by the first conductive pattern in the input sensing part illustrated in FIG. 6. FIG. 8 is a view illustrating components formed by the second conductive pattern in the input sensing part illustrated in FIG. 6.

In FIGS. 7 and 8, the active area AA is illustrated, and the inactive area NAA is omitted.

Referring to FIG. 7, the second sensing lines RL1 to RLk, the extending lines EXL, and the connecting patterns CP may be disposed in the same layer as each other. The second sensing lines RL1 to RLk, the extending lines EXL, and the connecting patterns CP may be formed by being concurrently or substantially simultaneously subjected to patterning with the same material. The second sensing lines RL1 to RLk, the extending lines EXL, and the connecting patterns CP may be formed by the first conductive pattern CTL1 illustrated in FIG. 5.

An insulating layer may be disposed on the second sensing lines RL1 to RLk, the extending lines EXL, and the connecting patterns CP, and the contact holes T-CH and R-CH may be defined in (e.g., may penetrate) the insulating layer.

Referring to FIG. 8, the first sensing parts SP1, the second sensing parts SP2, and the extending patterns EP may be disposed in the same layer as each other. The first sensing parts SP1, the second sensing parts P2, and the extending pattern EP may be formed by being concurrently or substantially simultaneously subjected to patterning with the same material. The first sensing parts SP1, the second sensing parts P2, and the extending pattern EP may be formed by the second conductive pattern CTL2 illustrated in FIG. 5.

Referring to FIGS. 7 and 8, the first sensing parts SP1, the second sensing parts P2, and the extending pattern EP may be disposed in a layer different from the layer in which the second sensing lines RL1 to RLk, the extending lines EXL, and the connecting patterns CP are disposed. The second conductive pattern CTL2 may be disposed above the first conductive pattern CTL1. Accordingly, the first sensing parts SP1, the second sensing parts SP2, and the extending pattern EP may be disposed above the second sensing lines RL1 to RLk, the extending lines EXL, and the connecting patterns CP.

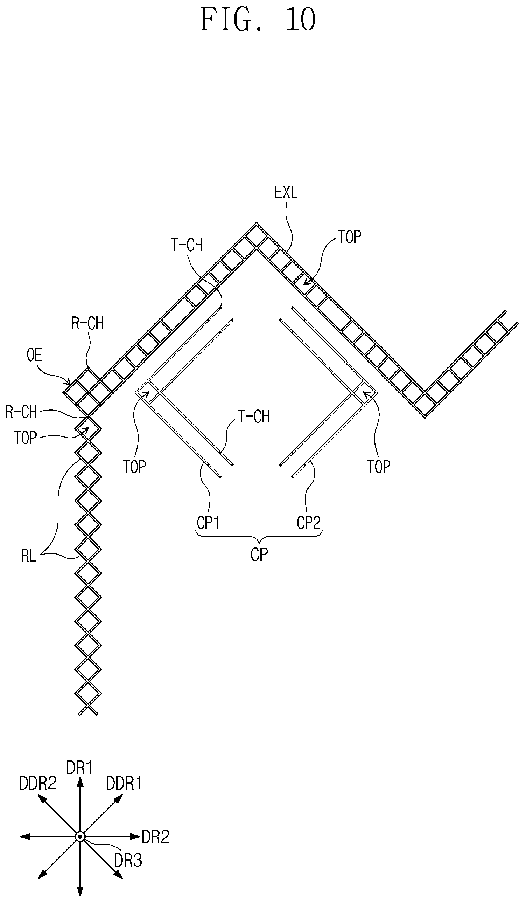

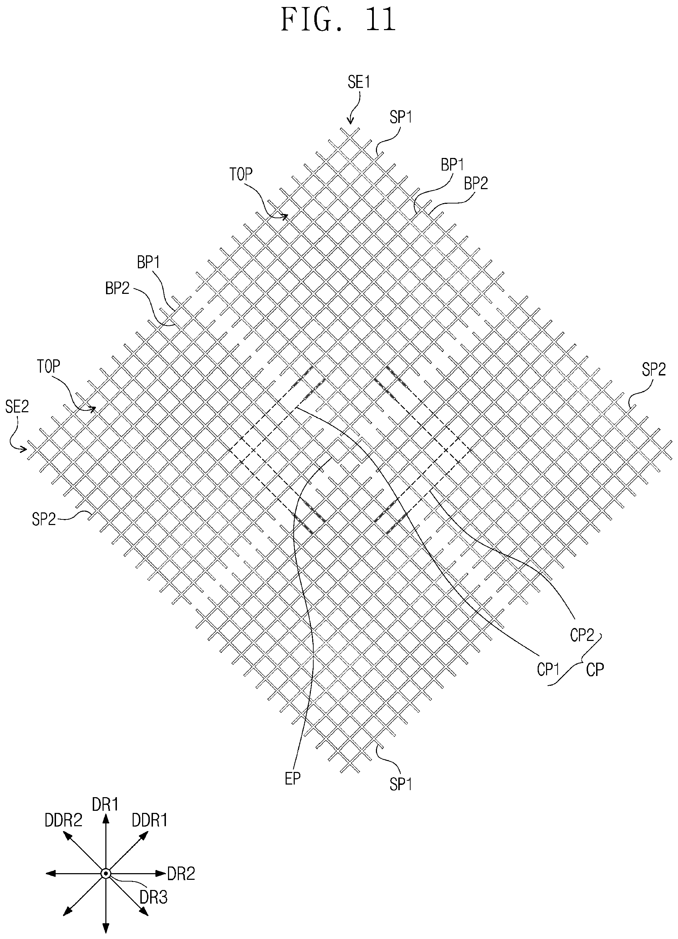

FIG. 9 is an enlarged view of two first sensing parts and two second sensing parts that are adjacent to each other, an extending pattern, a connecting pattern, an extending line, and a second sensing line adjacent to the first and second sensing parts in FIG. 6. FIG. 10 is a view separately illustrating the second sensing line, the connecting pattern, and the extending line illustrated in FIG. 9. FIG. 11 is a view separately illustrating the first and second sensing parts and the extending pattern illustrated in FIG. 9.

FIG. 9 is a view illustrating a configuration of the input sensing part illustrated in FIG. 6 in more detail. The second sensing line RL illustrated in FIGS. 9 and 10 is assigned with the reference numeral "RL" without a sequence number. FIG. 10 may correspond to the configuration described above with reference to FIG. 7, and FIG. 11 may correspond to the configuration described above with reference to FIG. 8. In FIGS. 9 and 10, the second sensing line RL and the extending line EXL are illustrated by thick lines. In FIG. 11, portions where first and second connecting patterns CP1 and CP2 are disposed are illustrated by dotted lines.

Referring to FIGS. 9, 10, and 11, the first and second sensing parts SP1 and SP2 and the extending pattern EP may be disposed above the second sensing line RL, the connecting pattern CP, and the extending line EXL. The first sensing patterns SP1 may be arranged along the first direction DR1. The second sensing parts SP2 may be arranged along the second direction DR2 between the first sensing parts SP1, and may be spaced apart from the first sensing parts SP1.

The first sensing parts SP1 and the second sensing parts SP2 may substantially have a mesh shape. Each of the first and second sensing parts SP1 and SP2 may include a plurality of first branch portions BP1 extending in the first diagonal direction DDR1, and a plurality of second branch portions BP2 extending in the second diagonal direction DDR2, to have the mesh shape.

The first branch portions BP1 and the second branch portions BP2 of each of the first and second sensing parts SP1 and SP2 may cross each other, and may be integrally formed with each other. Touch openings TOP having a rhombic shape may be defined by the first branch portions BP1 and the second branch portions BP2.

An emissive area LA may be disposed in a corresponding touch opening TOP when viewed on the plane (e.g., in a plan view). A light emitting element OLED may be disposed in the emissive area LA. The emissive area LA may be the emissive area LA illustrated in FIG. 5. Although one emissive area LA is illustrated as an example, a plurality of emissive areas LA may be disposed in the touch openings TOP, respectively.

The first and second sensing parts SP1 and SP2 may be disposed in the non-emissive area NLA. Because the first and second sensing parts SP1 and SP2 are disposed in the non-emissive area NLA, light generated from the emissive areas LA may be normally output without being affected by the first and second sensing parts SP1 and SP2.

The connecting pattern CP may extend so as not to overlap with the extending pattern EP, and may connect the first sensing parts SP1 to each other. The connecting pattern CP may be connected to the first sensing parts SP1 through a plurality of contact holes TC-CH. For example, the contact holes TC-CH are illustrated as dots in FIG. 9.

The connecting pattern CP may extend toward the first sensing parts SP1 via the second sensing parts SP2. Accordingly, the connecting pattern CP may overlap with portions of the second sensing parts SP2 when viewed on the plane (e.g., in a plan view).

The connecting pattern CP may include the first connecting pattern CP1 and the second connecting pattern CP2 that have shapes symmetrical to or substantially symmetrical to each other in the second direction DR2. The first connecting pattern CP1 and the second connecting pattern CP2 may have a bent shape.

The first connecting pattern CP1 may extend toward the first sensing parts SP1 via one of the two second sensing parts SP2. The second connecting pattern CP2 may extend toward the first sensing parts SP1 via the other one of the two second sensing parts SP2. The first connecting pattern CP1 and the second connecting pattern CP2 may be connected to the first sensing parts SP1 through the contact holes TC-CH overlapping with the first sensing parts SP1.

A bent portion of the first connecting pattern CP1 and a bent portion of the second connecting pattern CP2 may overlap with the second sensing parts SP2, respectively. A single touch opening TOP may be defined in each of the bent portion of the first connecting pattern CP1 and the bent portion of the second connecting pattern CP2. Each of the first connecting pattern CP1 and the second connecting pattern CP2 may include two mesh lines that extend toward the first sensing parts SP1.

As illustrated in FIGS. 9 and 11, among the mesh lines of the second sensing parts SP2, mesh lines extending parallel to the mesh lines of the first and second connecting patterns CP1 and CP2 may be omitted. Among the mesh lines of the second sensing parts SP2, mesh lines extending to cross the mesh lines of the first and second connecting patterns CP1 and CP2 may remain. Accordingly, as illustrated in FIG. 11, mesh lines may not be disposed in portions of the second sensing parts SP2.

The shapes of the first and second connecting patterns CP1 and CP2 are illustrated as an example. The first and second connecting patterns CP1 and CP2 may have various suitable shapes without being limited to the shapes illustrated in FIG. 9.

When viewed on the plane, the extending pattern EP may be disposed between the first sensing parts SP1 and between the second sensing parts SP2, and may extend from the second sensing parts SP2. The second sensing parts SP2 and the extending pattern EP may be integrally formed with each other. The extending pattern EP may have a mesh shape that defines a plurality of touch openings TOP.

The second sensing line RL may extend in the first direction DR1, and may have a mesh shape that defines a plurality of touch openings TOP. One end OE of the second sensing line RL may overlap with a central portion of one of the second sensing parts SP2 (e.g., the left second sensing part SP2) when viewed on the plane (e.g., in a plan view). The one end OE of the second sensing line RL may be connected to the central portion of the one second sensing part SP2.

The one end OE of the second sensing line RL may be connected to the one second sensing part SP2 through a plurality of contact holes R-CH. Although in FIG. 6, each of the second sensing lines RL1 to RLk is connected to the corresponding second sensing electrode SE2 through the contact hole R-CH, the contact hole R-CH may be substantially provided in plural numbers as illustrated in FIG. 9.

The one end OE of the second sensing line RL may have a mesh shape. The one end OE of the second sensing line RL may be defined as a portion of the second sensing line RL that overlaps with the contact holes R-CH. For example, the one end OE of the second sensing line RL may be defined as a portion in which four touch openings TOP arranged in the first and second diagonal directions DDR1 and DDR2 are defined.

The extending line EXL may extend in a zigzag pattern in the second direction DR2, and may have a mesh shape that defines a plurality of touch openings TOP. The extending line EXL may be integrally formed with the second sensing line RL, and may extend from the second sensing line RL. The extending line EXL may extend in a bent shape, such as a zigzag pattern, to bypass the first and second connecting patterns CP1 and CP2.

When viewed on the plane, the extending line EXL may extend to sequentially pass through one second sensing part SP2 connected to the second sensing line RL, one first sensing part SP1 adjacent to the one second sensing part SP2, and the other second sensing part SP2.

For example, when viewed on the plane (e.g., in a plan view), the extending line EXL may extend via the upper first sensing part SP1 of the first sensing parts SP1. Accordingly, the extending line EXL may overlap with portions of the second sensing parts SP2 and a portion of the upper first sensing part SP1.

FIG. 12 is a sectional view taken along the line I-I' illustrated in FIG. 9. FIG. 13 is a sectional view taken along the line II-II' illustrated in FIG. 9.

Referring to FIGS. 12 and 13, the base layer BSL may be disposed on the thin film encapsulation layer TFE, and the connecting pattern CP, the second sensing line RL, and the extending line EXL may be disposed on the base layer BSL. On the base layer BSL, the extending line EXL may be integrally formed with the second sensing line RL, and may extend from the second sensing line RL. Although the first connecting pattern CP1 of the connecting pattern CP is illustrated, the second connecting pattern CP2 may also be disposed on the base layer BSL.

The insulating layer TINS may be disposed on the base layer BSL, the connecting pattern CP, the second sensing line RL, and the extending line EXL. The first and second sensing parts SP1 and SP2 may be disposed on the insulating layer TINS. The extending pattern EP illustrated in FIG. 9 may also be disposed on the insulating layer TINS.

The first sensing part SP1 may be connected to the connecting pattern CP through the contact holes T-CH defined in the insulating layer TINS. The second sensing part SP2 may be connected to the second sensing line RL through the contact holes R-CH defined in the insulating layer TINS.

Referring to FIGS. 6 through 11, the second sensing lines RL1 to RLk may be connected to the second sensing electrodes SE2 in the active area AA without the use of the extending lines EXL. When the extending lines EXL are not used, a difference between capacitances may be increased as follows.

In FIG. 6, a first capacitance may be formed by a second sensing part SP2' connected to a second sensing line RL-1' and a first sensing part SP1' adjacent to the second sensing part SP2'. A second capacitance may be formed by a second sensing part SP2" not connected to the second sensing line RL-1' and a first sensing part SP1" adjacent to the second sensing part SP2". The second capacitance may be defined as a capacitance formed around the first capacitance.

When the second sensing line RL-1' is connected to the second sensing part SP2' and is not connected to the second sensing part SP2", the first capacitance formed by the second sensing part SP2' may be much greater than the second capacitance formed by the second sensing part SP2". For example, the first capacitance may be 1.5 times or more greater than the second capacitance formed around the first capacitance. As the difference between the first and second capacitances is increased, the input sensing part ISP may not normally operate.

In general, a resistance and a capacitance have a reciprocal relationship. As the resistance is increased, the resistance may further obstruct a current flow. Accordingly, as the resistance is increased, the capacitance may be decreased. The resistance may be inversely proportional to the thickness of a line, and may be proportional to the length of the line.

Not only the second sensing line RL-1' but also the extending line EXL may be connected to the second sensing part SP2'. In other words, the length of the line connected to the second sensing part SP2' may be increased. Because the length of the line connected to the second sensing part SP2' is increased, a line resistance may be increased.

Because the line resistance to the second sensing part SP2' is increased, the first capacitance formed by the second sensing part SP2' and the first sensing part SP1' may be decreased. As compared with when only the second sensing line RL-1' is connected to the second sensing part SP2', the first capacitance may be decreased when the second sensing line RL-1' and the extending line EXL are connected to the second sensing part SP2'. Accordingly, the difference between the first capacitance and the second capacitance may be decreased. Thus, a malfunction of the input sensing part ISP may be prevented or substantially prevented.

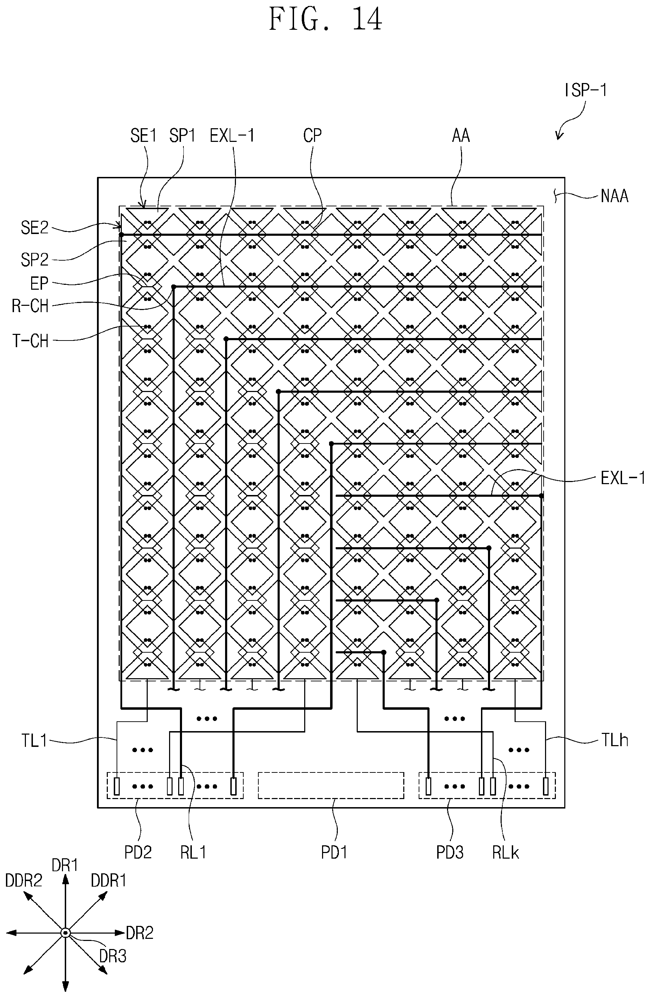

FIG. 14 is a view illustrating a configuration of an input sensing part.

FIG. 14 is a plan view corresponding to the configuration described above with reference to FIG. 6. Hereinafter, the configuration illustrated in FIG. 14 will be described focusing on the components different from the components described above with reference to FIG. 6.

Referring to FIG. 14, the input sensing part ISP-1 may include a plurality of extending lines EXL-1. The extending lines EXL-1 may extend from the second sensing lines RL1 to RLk in the second direction DR2. The extending lines EXL-1 may extend to cross the connecting patterns CP while being insulated from the connecting patterns CP. In addition, the extending lines EXL-1 may extend to overlap with the extending patterns EP. In other words, unlike in the configuration described above with reference to FIG. 6, the extending lines EXL-1 may not extend to bypass the connecting patterns CP.

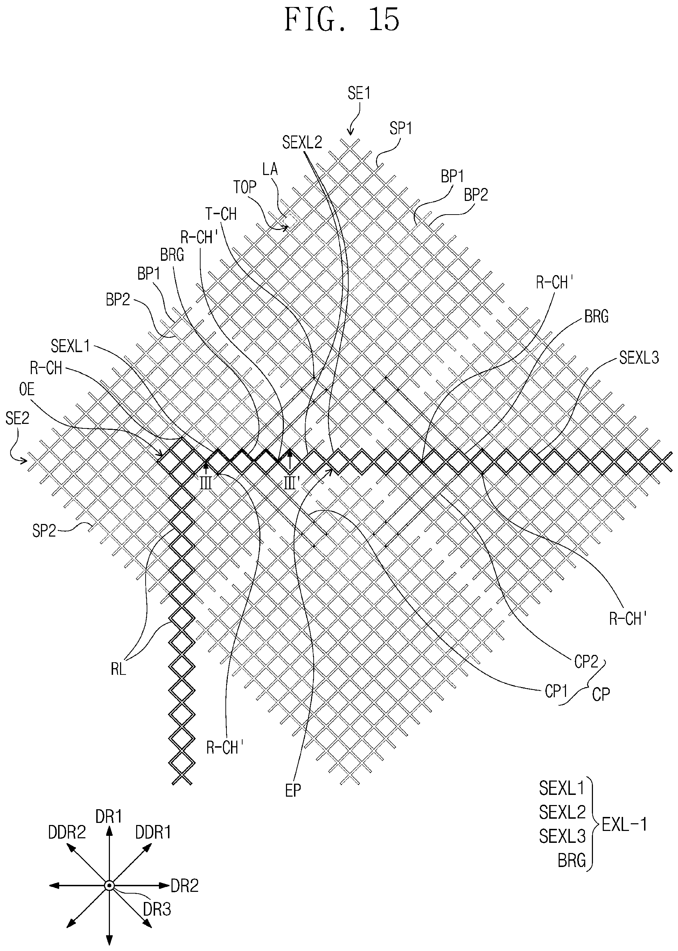

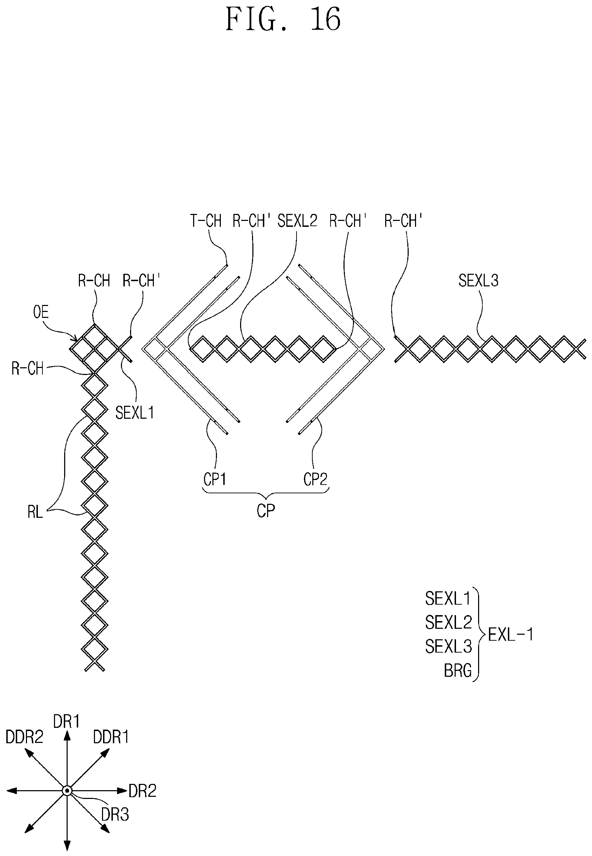

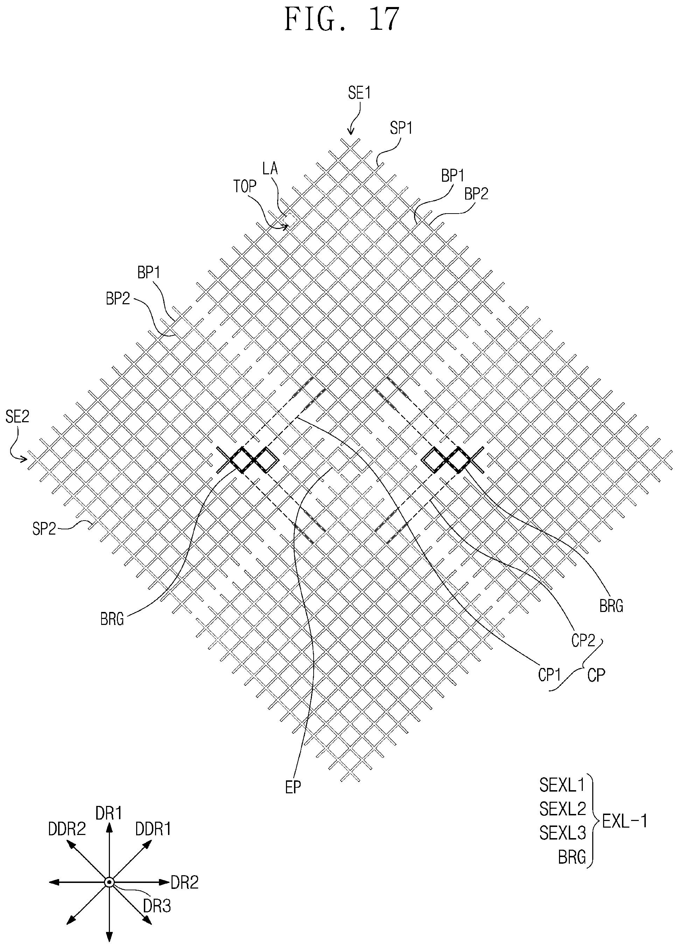

FIG. 15 is an enlarged view of two first sensing parts and two second sensing parts that are adjacent to each other, an extending pattern, a connecting pattern, an extending line, and a second sensing line adjacent to the first and second sensing parts in FIG. 14. FIG. 16 is a view separately illustrating the second sensing line, the connecting pattern, and first, second, and third sub-extending lines illustrated in FIG. 15. FIG. 17 is a view separately illustrating the first and second sensing parts, the extending pattern, and bridge portions illustrated in FIG. 15.

FIG. 15 may correspond to the plan view described above with reference to FIG. 9. FIG. 16 may correspond to the plan view described above with reference to FIG. 10. FIG. 17 may correspond to the plan view described above with reference to FIG. 11.

Referring to FIGS. 15, 16, and 17, the extending line EXL-1 may include a first sub-extending line SEXL1, a second sub-extending line SEXL2, a third sub-extending line SEXL3, and a plurality of bridge portions BRG. The first, second, and third sub-extending lines SEXL1, SEXL2, and SEXL3 may be disposed in the same layer as that of the second sensing line RL. The bridge portions BRG may be disposed in the same layer as that of the first and second sensing parts SP1 and SP2.

The first sub-extending line SEXL1 may extend from the second sensing line RL. In more detail, the first sub-extending line SEXL1 may extend from one end OE of the second sensing line RL.

The second sub-extending line SEXL2 and the third sub-extending line SEXL3 may be spaced apart from the first sub-extending line SEXL1 in the second direction DR2, and may be arranged along the second direction DR2. The second sub-extending line SEXL2 may be adjacent to the first sub-extending line SEXL1. The second sub-extending line SEXL2 may be disposed between the first sub-extending line SEXL1 and the third sub-extending line SEXL3.

When viewed on the plane, the second sub-extending line SEXL2 may overlap with the extending pattern EP and portions of the second sensing parts SP2 that are adjacent to the extending pattern EP. The second sub-extending line SEXL2 may be disposed in a layer different from the layer in which the extending pattern EP is disposed, and may be insulated from the extending pattern EP. For example, the extending pattern EP may be disposed on the second sub-extending line SEXL2.

When viewed on the plane, the bridge portions BRG may overlap with the connecting patterns CP, and may extend to cross the connecting patterns CP. The bridge portions BRG may be disposed in a layer different from the layer in which the connecting patterns CP are disposed, and may be insulated from the connecting patterns CP. For example, the bridge portions BRG may be disposed on the connecting patterns CP. In FIG. 17, the portions where the connecting patterns CP are disposed are illustrated by dotted lines.

One bridge portion BRG may be disposed between the first sub-extending line SEXL1 and the second sub-extending line SEXL2. Another bridge portion BRG may be disposed between the second sub-extending line SEXL2 and the third sub-extending line SEXL3.

The first sub-extending line SEXL1 and the second sub-extending line SEXL2 may be connected to the corresponding bridge portion BRG through contact holes R-CH'. The second sub-extending line SEXL2 and the third sub-extending line SEXL3 may be connected to the corresponding bridge portion BRG through contact holes R-CH'. In the areas where the connecting patterns CP are disposed, the first and second sub-extending lines SEXL1 and SEXL2 and the second and third sub-extending lines SEXL2 and SEXL3 may be connected through the bridge portions BRG.

As illustrated in FIG. 17, the bridge portions BRG may be disposed inside the second sensing parts SP2, and may be spaced (e.g., separated) from the second sensing parts SP2.

FIG. 15 illustrates a partial area of FIG. 14. As such, a plurality of third sub-extending lines SEXL3 and a plurality of bridge portions BRG overlapping with the connecting patterns CP and connecting the third sub-extending lines SEXL3 may be continuously disposed to the right from the area illustrated in FIG. 15. In the areas where the connecting patterns CP are disposed, the third sub-extending lines SEXL3 may be connected by the bridge portions BRG.

The configuration in which the third sub-extending lines SEXL3 are connected by the bridge portions BRG may be the same or substantially the same as the configuration in which the second sub-extending line SEXL2 and the third sub-extending line SEXL3 are connected through the bridge portion BRG.

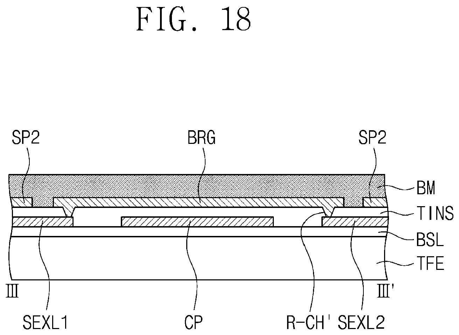

FIG. 18 is a sectional view taken along the line III-III' illustrated in FIG. 15.

Referring to FIG. 18, the first sub-extending line SEXL1, the second sub-extending line SEXL2, and the connecting pattern CP may be disposed on a base layer BSL. The third sub-extending line SEXL3 may also be disposed on the base layer BSL.

An insulating layer TINS may be disposed on the base layer BSL, the first sub-extending line SEXL1, the second sub-extending line SEXL2, and the connecting pattern CP. The bridge portion BRG and the second sensing part SP2 may be disposed on the insulating layer TINS. The bridge portion BRG and the second sensing part SP2 may be spaced apart from each other. The bridge portion BRG may be connected to the first sub-extending line SEXL1 and the second sub-extending line SEXL2 through the contact holes R-CH' defined in the insulating layer TINS.

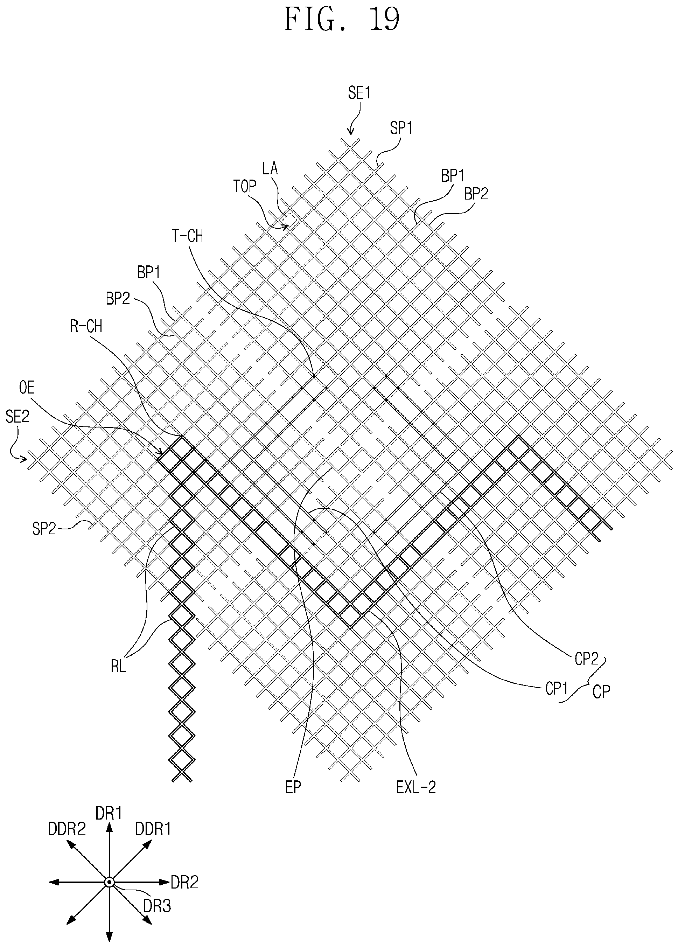

FIGS. 19 through 23 are views illustrating configurations of extending lines.

FIGS. 19 through 21 are enlarged plan views corresponding to that described above with reference to FIG. 9, and FIGS. 22 and 23 are plan views corresponding to that described above with reference to FIG. 6.

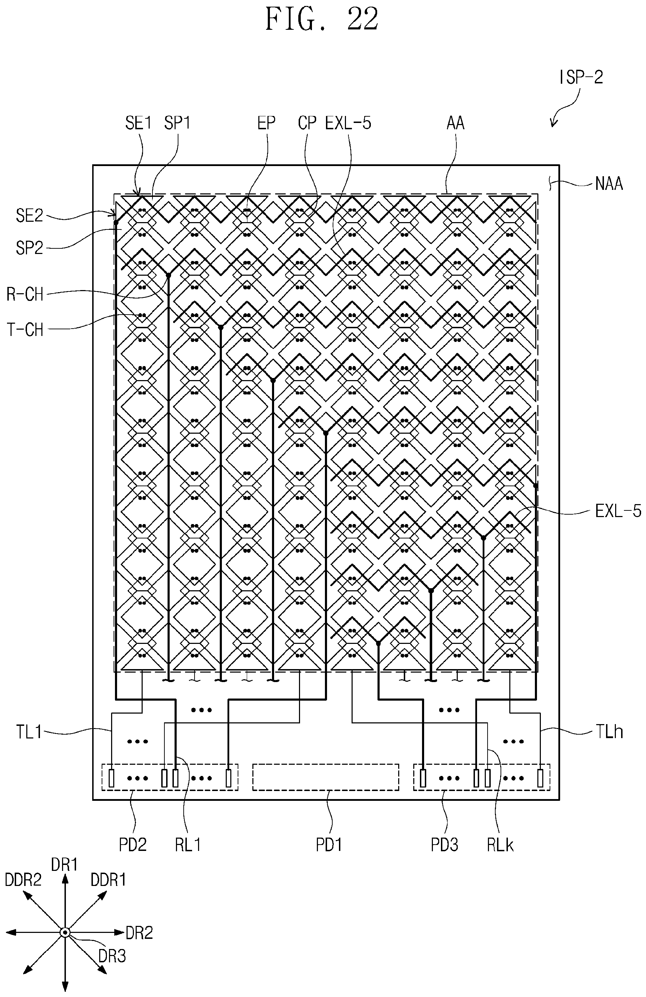

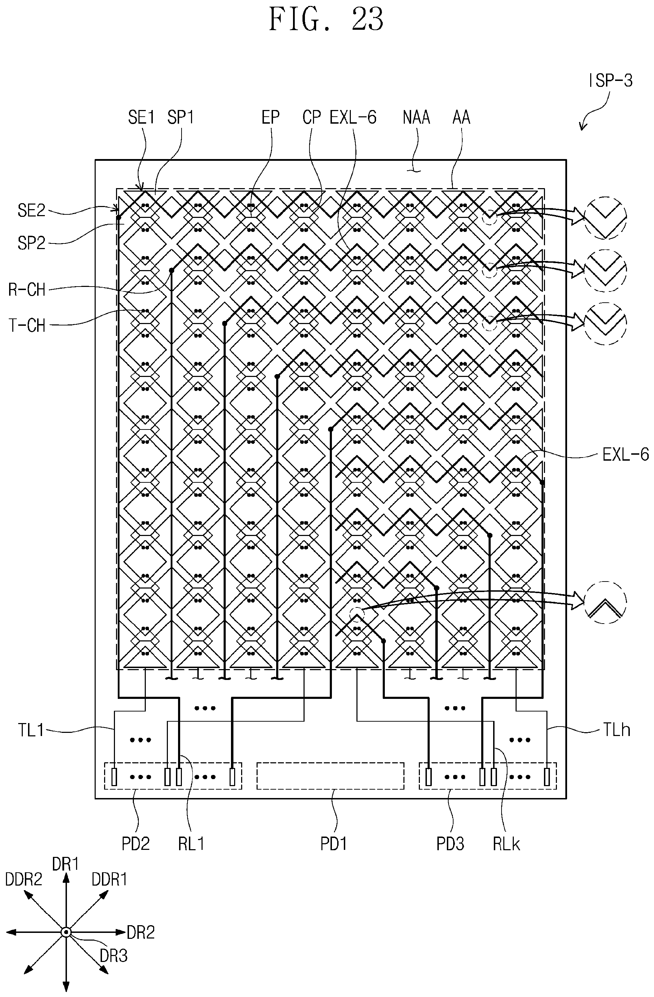

Hereinafter, the configurations illustrated in FIGS. 19 through 21 will be described focusing on components different from the components described above with reference to FIG. 9, and the configurations illustrated in FIGS. 22 and 23 will be described focusing on components different from the components described above with reference to FIG. 6.

Referring to FIG. 19, unlike the extending line EXL illustrated in FIG. 9, an extending line EXL-2 may extend via a lower first sensing part SP1 of the first sensing parts SP1 when viewed on the plane (e.g., in a plan view). The extending line EXL-2 may extend in zigzags in the second direction DR2.

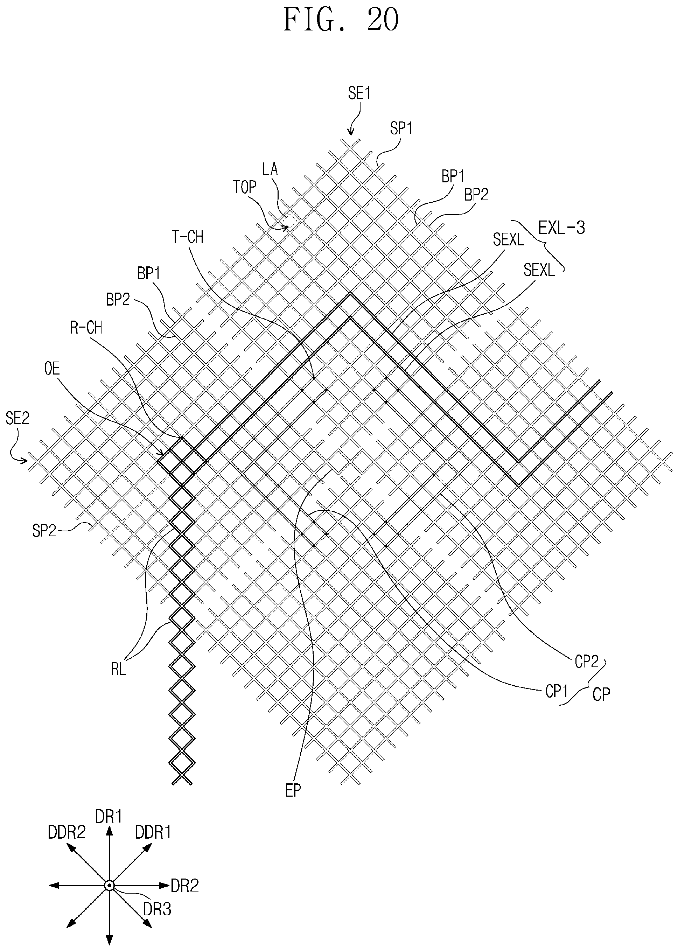

Referring to FIG. 20, an extending line EXL-3 may include a plurality of sub-extending lines SEXL that extend parallel to or substantially parallel to each other. The sub-extending line SEXL may extend in zigzags in the second direction DR2.

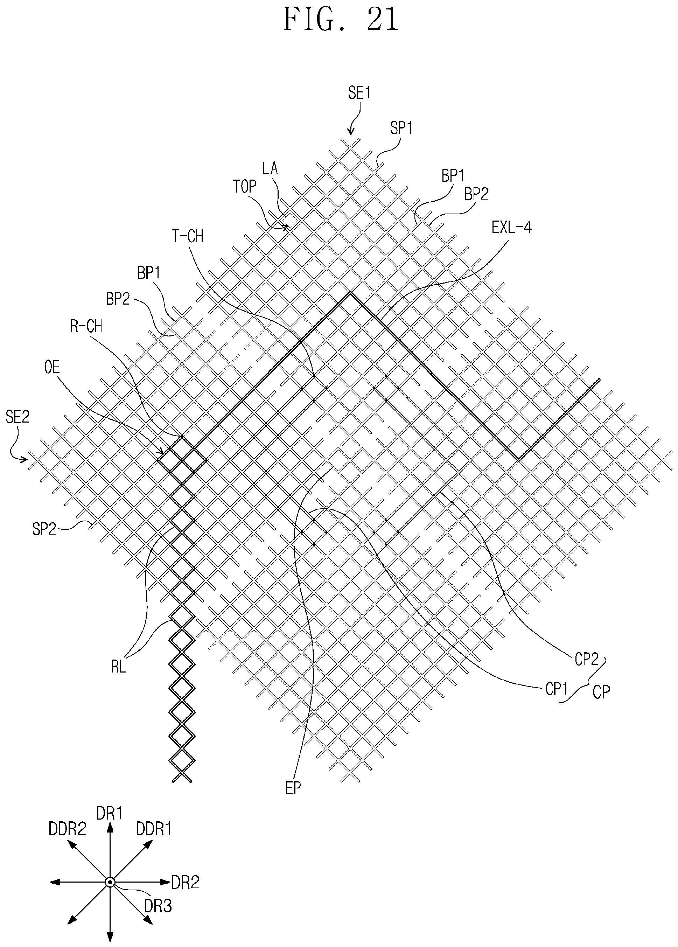

Referring to FIG. 21, an extending line EXL-4 may be provided as a single line.

Referring to FIG. 22, an input sensing part ISP-2 may include a plurality of second extending lines EXL-5. Some of the second extending lines EXL-5 may extend in both directions (e.g., opposite directions) parallel to or substantially parallel to the second direction DR2. For example, extending lines EXL-5 connected to first ends of second sensing lines other than the leftmost second sensing line RL1 and the rightmost second sensing line RLk may extend from the first ends of the second sensing lines other than the second sensing lines RL1 and RLk in both the directions (e.g., opposite directions) parallel to or substantially parallel to the second direction DR2.

Referring to FIG. 23, an input sensing part ISP-3 may include a plurality of second extending lines EXL-6. The extending lines EXL-6 may have different widths. For example, among the extending lines EXL-6, a p^{th} extending line EXL-6 and a (p+1)^{th} extending line EXL-6 may have different widths from each other. Here, "p" is a natural number. The widths of the extending lines EXL-6 may be gradually decreased from the upper end toward the lower end of the active area AA.

As used herein, the term "thickness" may be defined as a numerical value measured in a direction perpendicular to or substantially perpendicular to an extension direction of a corresponding component.

As the lengths of the extending lines EXL-6 are increased, line resistances may be increased. The lengths of the extending lines EXL-6 may be decreased from the upper end toward the lower end of the active area AA. Accordingly, based on the lengths, the line resistances of the extending lines EXL-6 may be gradually decreased from the upper end toward the lower end of the active area AA.

A resistance may be inversely proportional to the width of a line. The widths of the extending lines EXL-6 may be gradually decreased from the upper end toward the lower end of the active area AA. Accordingly, based on the widths, the line resistances of the extending lines EXL-6 may be gradually increased from the upper end toward the lower end of the active area AA.

While the line resistances of the extending lines EXL-6 are gradually decreased from the upper end toward the lower end of the active area AA based on the lengths, the line resistances of the extending lines EXL-6 may be gradually increased from the upper end toward the lower end of the active area AA based on the widths. In this case, the deviations of the line resistances of the extending lines EXL-6 may be decreased.

The second sensing lines connected to the second sensing electrodes may not be disposed in the inactive area, but may be disposed in the active area. Accordingly, the inactive area of the input sensing part may be reduced.

In addition, the extending lines may be connected to the second sensing lines. Accordingly, a line resistance may be increased. Because the line resistance is increased, the first capacitances formed by the second sensing parts connected to the second sensing lines may be decreased. Thus, the difference between the first capacitances and the second capacitances around the first capacitances may be decreased, and a malfunction of the input sensing part may be prevented or substantially prevented.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present invention. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated.

## Claims

1. An input sensing part (ISP) comprising:
a first sensing electrode (SE1) in an active area (AA), and extending in a first direction (DR1);
a second sensing electrode (SE2) in the active area, and extending in a second direction (DR2) crossing the first direction, the second sensing electrode crossing the first sensing electrode while being insulated from the first sensing electrode;
a first sensing line (TL1 to TLh) in an inactive area (NAA) around the active area, and connected to the first sensing electrode (SE1);
a second sensing line (RL1 to RLk) extending in the first direction in the active area, and connected to the second sensing electrode (SE2); and
**characterized in** an extending line (EXL) extending in the second direction in the active area, connected to the second sensing line at one end and electrically floating at the other end.

2. The input sensing part of claim 1, wherein the extending line is bent at least once, and extends in zigzags in the second direction.

3. The input sensing part of claim 1 or 2, wherein the extending line is located in the same layer as that of the second sensing line, and/or wherein the extending line is integral with the second sensing line.

4. The input sensing part of any one of the preceding claims, wherein the first sensing electrode comprises:
two first sensing parts along the first direction; and
a connecting pattern between the two first sensing parts and connecting the two first sensing parts to each other,
wherein the second sensing electrode comprises:
two second sensing parts along the second direction between the two first sensing parts and spaced from the two first sensing parts; and
an extending pattern between the two first sensing parts and between the two second sensing parts, and extending from the two second sensing parts,
wherein the extending pattern does not overlap with the connecting pattern when viewed on a plane, and
wherein the connecting pattern extends toward the two first sensing parts via the two second sensing parts.

5. The input sensing part of claim 4, wherein the extending line extends to bypass the connecting pattern when viewed on the plane.

6. The input sensing part of claim 4, wherein the extending line and the connecting pattern are located in the same layer, the first and second sensing parts and the extending pattern are located in the same layer, and the extending line and the connecting pattern are located in a layer different from the layer in which the first and second sensing parts and the extending pattern are located.

7. The input sensing part of claim 4, wherein, when viewed on the plane, one end of the second sensing line overlaps with one of the second sensing parts from among the two second sensing parts and is connected to the one of the second sensing parts, and
wherein the extending line extends from the one end of the second sensing line in one direction.

8. The input sensing part of claim 7, wherein the extending line extends via the one of the second sensing parts, one first sensing part adjacent to the one of the second sensing parts from among the two first sensing parts, and the other second sensing part from among the two second sensing parts.

9. The input sensing part of any one of claims 4 to 8, wherein the first and second sensing parts, the second sensing line, and the extending line have a mesh shape in which a plurality of touch openings are defined.

10. The input sensing part of any one of claims 4 to 9, wherein the extending line extends via an upper first sensing part from among the two first sensing parts when viewed on the plane or wherein the extending line extends via a lower first sensing part from among the two first sensing parts when viewed on the plane.

11. The input sensing part of claim 4, wherein the extending line crosses the connecting pattern while being insulated from the connecting pattern, and extends to overlap with the extending pattern.

12. The input sensing part of claim 11, wherein the extending line comprises:
a first sub-extending line extending from the second sensing line;
a second sub-extending line spaced from the first sub-extending line in the second direction, and located in a layer different from a layer in which the extending pattern is located, the second sub-extending line overlapping with the extending pattern when viewed on the plane; and
a bridge portion crossing the connecting pattern while being insulated from the connecting pattern, the bridge portion connecting the first sub-extending line and the second sub-extending line to each other.

13. The input sensing part of any one of the preceding claims, wherein the extending line comprises a plurality of sub-extending lines extending parallel to each other, or wherein the extending line comprises a single line, or wherein the extending line bidirectionally extends from one end of the second sensing line.

14. The input sensing part of any one of the preceding claims, wherein the second sensing electrode comprises a plurality of second sensing electrodes, the second sensing line comprises a plurality of second sensing lines, and the extending line comprises a plurality of extending lines,
wherein the plurality of second sensing lines are connected to the plurality of second sensing electrodes, respectively,
wherein the plurality of extending lines are connected to the plurality of second sensing lines, respectively, and
wherein among the plurality of extending lines, an h^{th} extending line and an (h+1)^{th} extending line have different widths from each other, where h is a natural number.

15. A display device comprising:
a display panel; and
an input sensing part according to any one of the preceding claims on the display panel.

## Patentansprüche

1. Eingabeerfassungsteil (ISP), umfassend:
eine erste Erfassungselektrode (SE1) in einem aktiven Bereich (AA) und sich in einer ersten Richtung (DR1) erstreckend;
eine zweite Erfassungselektrode (SE2) in dem aktiven Bereich und sich in einer zweiten Richtung (DR2) erstreckend, welche die erste Richtung kreuzt, wobei die zweite Erfassungselektrode die erste Erfassungselektrode kreuzt, während sie von der ersten Erfassungselektrode isoliert ist;
eine erste Erfassungsleitung (TL1 bis TLh) in einem inaktiven Bereich (NAA) um den aktiven Bereich und mit der ersten Erfassungselektrode (SE1) verbunden;
eine zweite Erfassungsleitung (RL1 bis RLk), die sich in der ersten Richtung in dem aktiven Bereich erstreckt und mit der zweiten Erfassungselektrode (SE2) verbunden ist; und
**gekennzeichnet durch**
eine Erstreckungsleitung (EXL), die sich in der zweiten Richtung in dem aktiven Bereich erstreckt, an einem Ende mit der zweiten Erfassungsleitung verbunden und an dem anderen Ende elektrisch schwebend.

2. Eingabeerfassungsteil nach Anspruch 1, wobei die Erstreckungsleitung zumindest einmal gebogen ist und sich zickzackförmig in der zweiten Richtung erstreckt.

3. Eingabeerfassungsteil nach Anspruch 1 oder 2, wobei sich die Erstreckungsleitung in derselben Schicht wie diejenige der zweiten Erfassungsleitung befindet und/oder wobei die Erstreckungsleitung einstückig mit der zweiten Erfassungsleitung ist.

4. Eingabeerfassungsteil nach einem der vorhergehenden Ansprüche, wobei die erste Erfassungselektrode Folgendes umfasst:
zwei erste Erfassungsteile entlang der ersten Richtung; und
ein Verbindungsmuster zwischen den zwei ersten Erfassungsteilen und die zwei ersten Erfassungsteile miteinander verbindend,
wobei die zweite Erfassungselektrode Folgendes umfasst:
zwei zweite Erfassungsteile entlang der zweiten Richtung zwischen den zwei ersten Erfassungsteilen und beabstandet von den zwei ersten Erfassungsteilen; und
ein Erstreckungsmuster zwischen den zwei ersten Erfassungsteilen und zwischen den zwei zweiten Erfassungsteilen und sich von den zwei zweiten Erfassungsteilen erstreckend,
wobei das Erstreckungsmuster nicht mit dem Verbindungsmuster überlappt, wenn auf einer Ebene betrachtet, und
wobei sich das Verbindungsmuster zu den zwei ersten Erfassungsteilen über die zwei zweiten Erfassungsteile hin erstreckt.

5. Eingabeerfassungsteil nach Anspruch 4, wobei sich die Erstreckungsleitung erstreckt, um das Verbindungsmuster zu umgehen, wenn in der Ebene betrachtet.

6. Eingabeerfassungsteil nach Anspruch 4, wobei sich die Erstreckungsleitung und das Verbindungsmuster in derselben Schicht befinden, sich das erste und das zweite Erfassungsteil und das Erstreckungsmuster in derselben Schicht befinden und sich die Erstreckungsleitung und das Verbindungsmuster in einer Schicht befinden, die sich von der Schicht unterscheidet, in der sich das erste und das zweite Erfassungsteil und das Erstreckungsmuster befinden.

7. Eingabeerfassungsteil nach Anspruch 4, wobei, wenn in der Ebene betrachtet, ein Ende der zweiten Erfassungsleitung mit einem der zweiten Erfassungsteile unter den zwei zweiten Erfassungsteilen überlappt und mit dem einen von den zweiten Erfassungsteilen verbunden ist, und
wobei sich die Erstreckungsleitung von dem einen Ende der zweiten Erfassungsleitung in einer Richtung erstreckt.

8. Eingabeerfassungsteil nach Anspruch 7, wobei sich die Erstreckungsleitung über das eine von den zweiten Erfassungsteilen erstreckt, ein erstes Erfassungsteil benachbart zu dem einen von den zweiten Erfassungsteilen unter den zwei ersten Erfassungsteilen und dem anderen zweiten Erfassungsteil unter den zwei zweiten Erfassungsteilen.

9. Eingabeerfassungsteil nach einem der Ansprüche 4 bis 8, wobei das erste und das zweite Erfassungsteil, die zweite Erfassungsleitung und die Erstreckungsleitung eine Netzform aufweisen, in der eine Vielzahl von Berührungsöffnungen definiert ist.

10. Eingabeerfassungsteil nach einem der Ansprüche 4 bis 9, wobei sich die Erstreckungsleitung über ein oberes erstes Erfassungsteil unter den zwei ersten Erfassungsteilen erstreckt, wenn in der Ebene betrachtet, oder wobei sich die Erstreckungsleitung über ein unteres erstes Erfassungsteil unter den zwei ersten Erfassungsteilen erstreckt, wenn in der Ebene betrachtet.

11. Eingabeerfassungsteil nach Anspruch 4, wobei die Erstreckungsleitung das Verbindungsmuster kreuzt, während sie von dem Verbindungsmuster isoliert ist, und sich erstreckt, um mit dem Erstreckungsmuster zu überlappen.

12. Eingabeerfassungsteil nach Anspruch 11, wobei die Erstreckungsleitung Folgendes umfasst:
eine erste Untererstreckungsleitung, die sich von der zweiten Erfassungsleitung erstreckt;
eine zweite Untererstreckungsleitung, die von der ersten Untererstreckungsleitung in der zweiten Richtung beabstandet ist und sich in einer Schicht befindet, die sich von einer Schicht unterscheidet, in der sich das Erstreckungsmuster befindet, wobei die zweite Untererstreckungsleitung mit dem Erstreckungsmuster überlappt, wenn in der Ebene betrachtet; und
einen Brückenabschnitt, der das Verbindungsmuster kreuzt, während er von dem Verbindungsmuster isoliert ist, wobei der Brückenabschnitt die erste Untererstreckungsleitung und die zweite Untererstreckungsleitung miteinander verbindet.

13. Eingabeerfassungsteil nach einem der vorhergehenden Ansprüche, wobei die Erstreckungsleitung eine Vielzahl von Untererstreckungsleitungen umfasst, die sich parallel zueinander erstrecken, oder wobei die Erstreckungsleitung eine einzelne Leitung umfasst oder wobei sich die Erstreckungsleitung bidirektional von einem Ende der zweiten Erfassungsleitung erstreckt.

14. Eingabeerfassungsteil nach einem der vorhergehenden Ansprüche, wobei die zweite Erfassungselektrode eine Vielzahl von zweiten Erfassungselektroden umfasst, die zweite Erfassungsleitung eine Vielzahl von zweiten Erfassungsleitungen umfasst und die Erstreckungsleitung eine Vielzahl von Erstreckungsleitungen umfasst,
wobei die Vielzahl von zweiten Erfassungsleitungen jeweils mit der Vielzahl von zweiten Erfassungselektroden verbunden ist,
wobei die Vielzahl von Erstreckungsleitungen jeweils mit der Vielzahl von zweiten Erfassungsleitungen verbunden ist, und
wobei unter der Vielzahl von Erstreckungsleitungen eine h-te Erstreckungsleitung und eine (h+1)-te Erstreckungsleitung sich voneinander unterscheidende Breiten aufweisen, wobei h eine natürliche Zahl ist.

15. Anzeigevorrichtung, umfassend:
ein Anzeigefeld; und
ein Eingabeerfassungsteil nach einem der vorhergehenden Ansprüche auf dem Anzeigefeld.

## Revendications

1. Pièce de détection d'entrée (ISP) comprenant :
une première électrode de détection (SE1) dans une zone active (AA), et s'étendant dans une première direction (DR1) ;
une seconde électrode de détection (SE2) dans la zone active, et s'étendant dans une seconde direction (DR2) croisant la première direction, la seconde électrode de détection croisant la première électrode de détection tout en étant isolée de la première électrode de détection ;
une première ligne de détection (TL1 à TLh) dans une zone inactive (NAA) autour de la zone active, et connectée à la première électrode de détection (SEI) ;
une seconde ligne de détection (RL1 à RLk) s'étendant dans la première direction dans la zone active, et connectée à la seconde électrode de détection (SE2) ; et
**caractérisée par** une ligne d'extension (EXL) s'étendant dans la seconde direction dans la zone active, connectée à la seconde ligne de détection à une extrémité et flottant électriquement à l'autre extrémité.

2. Pièce de détection d'entrée de la revendication 1, dans laquelle la ligne d'extension est courbée au moins une fois, et s'étend en zigzags dans la seconde direction.

3. Pièce de détection d'entrée de la revendication 1 ou 2, dans laquelle la ligne d'extension est située dans la même couche que la seconde ligne de détection, et/ou dans laquelle la ligne d'extension est solidaire de la seconde ligne de détection.

4. Pièce de détection d'entrée de l'une quelconque des revendications précédentes, dans laquelle la première électrode de détection comprend :
deux premières pièces de détection le long de la première direction ; et
un motif de connexion entre les deux premières pièces de détection et connectant les deux premières pièces de détection l'une à l'autre,
dans laquelle la seconde électrode de détection comprend :
deux secondes pièces de détection le long de la seconde direction entre les deux premières pièces de détection et espacées des deux premières pièces de détection ; et
un motif d'extension entre les deux premières pièces de détection et entre les deux secondes pièces de détection, et s'étendant à partir des deux secondes pièces de détection, dans laquelle le motif d'extension ne chevauche pas le motif de connexion lorsqu'il est vu sur un plan, et
dans laquelle le motif de connexion s'étend vers les deux premières pièces de détection par l'intermédiaire des deux secondes pièces de détection.

5. Pièce de détection d'entrée de la revendication 4, dans laquelle la ligne d'extension s'étend pour contourner le motif de connexion lorsqu'elle est vue sur le plan.

6. Pièce de détection d'entrée de la revendication 4, dans laquelle la ligne d'extension et le motif de connexion sont situés dans la même couche, les première et seconde pièces de détection et le motif d'extension sont situés dans la même couche, et la ligne d'extension et le motif de connexion sont situés dans une couche différente de la couche où les première et seconde pièces de détection et le motif d'extension sont situés.

7. Pièce de détection d'entrée de la revendication 4, dans laquelle, lorsqu'elle est vue sur le plan, une extrémité de la seconde ligne de détection chevauche l'une des secondes pièces de détection parmi les deux secondes pièces de détection et est connectée à l'une des secondes pièces de détection, et
dans laquelle la ligne d'extension s'étend à partir de la première extrémité de la seconde ligne de détection dans une direction.

8. Pièce de détection d'entrée de la revendication 7, dans laquelle la ligne d'extension s'étend par l'intermédiaire de l'une des secondes pièces de détection, une première pièce de détection adjacente à l'une des secondes pièces de détection parmi les deux premières pièces de détection, et l'autre seconde pièce de détection parmi les deux secondes pièces de détection.

9. Pièce de détection d'entrée de l'une quelconque des revendications 4 à 8, dans laquelle les première et seconde pièces de détection, la seconde ligne de détection et la ligne d'extension présentent une forme maillée où sont définies une pluralité d'ouvertures tactiles.

10. Pièce de détection d'entrée de l'une quelconque des revendications 4 à 9, dans laquelle la ligne d'extension s'étend par l'intermédiaire d'une première pièce de détection supérieure parmi les deux premières pièces de détection lorsqu'elle est vue sur le plan ou dans laquelle la ligne d'extension s'étend par l'intermédiaire d'une première pièce de détection inférieure parmi les deux premières pièces de détection lorsqu'elle est vue sur le plan.

11. Pièce de détection d'entrée de la revendication 4, dans laquelle la ligne d'extension croise le motif de connexion tout en étant isolée du motif de connexion, et s'étend pour chevaucher le motif d'extension.

12. Pièce de détection d'entrée de la revendication 11, dans laquelle la ligne d'extension comprend :
une première ligne de sous-extension s'étendant à partir de la seconde ligne de détection ;
une seconde ligne de sous-extension espacée de la première ligne de sous-extension dans la seconde direction, et située dans une couche différente d'une couche où est situé le motif d'extension, la seconde ligne de sous-extension chevauchant le motif d'extension lorsqu'elle est vue sur le plan ; et
une partie de pont croisant le motif de connexion tout en étant isolée du motif de connexion, la partie de pont reliant la première ligne de sous-extension et la seconde ligne de sous-extension l'une à l'autre.

13. Pièce de détection d'entrée de l'une quelconque des revendications précédentes, dans laquelle la ligne d'extension comprend une pluralité de lignes de sous-extension s'étendant parallèlement les unes aux autres, ou dans laquelle la ligne d'extension comprend une seule ligne, ou dans laquelle la ligne d'extension s'étend de manière bidirectionnelle à partir d'une extrémité de la seconde ligne de détection.

14. Pièce de détection d'entrée de l'une quelconque des revendications précédentes, dans laquelle la seconde électrode de détection comprend une pluralité de secondes électrodes de détection, la seconde ligne de détection comprend une pluralité de secondes lignes de détection, et la ligne d'extension comprend une pluralité de lignes d'extension,
dans laquelle la pluralité de secondes lignes de détection sont connectées à la pluralité de secondes électrodes de détection, respectivement,
dans laquelle la pluralité de lignes d'extension sont connectées à la pluralité de secondes lignes de détection, respectivement, et
dans laquelle, parmi la pluralité de lignes d'extension, une h^{e} ligne d'extension et une (h+1)^{e} ligne d'extension présentent des largeurs différentes l'une de l'autre, où h est un nombre naturel.

15. Dispositif d'affichage comprenant :
un panneau d'affichage ; et
une pièce de détection d'entrée selon l'une quelconque des revendications précédentes sur le panneau d'affichage.
